# EUROPÄISCHE PATENTANMELDUNG

(11) **EP 4 257 565 A1**
(43) Veröffentlichungstag der Anmeldung: **11.10.2023**
(21) Anmeldenummer: 23166622.3
(22) Anmeldetag: 04.04.2023
(51) Int. Cl.: C03C 15/00, C03C 23/00, H01L 21/67

(54) **VERFAHREN UND SYSTEM ZUM AUSBILDEN EINER STRUKTUR IN EINEM WERKSTÜCK DURCH SELEKTIVES LASERÄTZEN**

(30) Priorität: 04.04.2022 DE 102022108013
(71) Anmelder: Pulsar Photonics GmbH, 52134 Herzogenrath (DE)
(72) Erfinder: Ryll, Joachim, 52159 Roetgen (DE); Eifel, Stephan, 50679 Köln (DE); Holtkamp, Jens, 41849 Wassenberg (DE)
(74) Vertreter: Patentanwälte Bauer Vorberg Kayser

(57) **Zusammenfassung**

Die vorliegende Erfindung betrifft ein Verfahren zum Ausbilden einer Struktur (1) in einem Werkstück (2) durch selektives Laserätzen, wobei
a) Werkstückmaterial (3) des Werkstücks (2) in einem zu der auszubildenden Struktur (1) korrespondierenden Werkstück-Bearbeitungsbereich (4) des Werkstücks (2) durch Laserstrahlung (5) strukturell modifiziert wird; und wobei
b) das modifizierte Werkstückmaterial (8) unter Einsatz eines Ätzmittels von dem Werkstück (2) entfernt wird,

Um bei einem solchen Verfahren eine Strukturausbildung in dem Werkstück (2) ohne Überätzungen oder nur mit einem geringen Maß an Überätzungen zu ermöglichen, wird vorgeschlagen, dass zum Entfernen des modifizierten Werkstückmaterials (8) eine von einer Ätzvorrichtung (9) erzeugte Ätzmittelfront (10) entlang des Werkstück-Bearbeitungsbereichs (4) geführt wird.

## Beschreibung

Die vorliegende Erfindung betrifft ein Verfahren zum Ausbilden einer Struktur in einem Werkstück durch selektives Laserätzen, wobei Werkstückmaterial des Werkstücks in einem zu der auszubildenden Struktur korrespondierenden Werkstück-Bearbeitungsbereich des Werkstücks durch Laserstrahlung strukturell modifiziert wird; und wobei das modifizierte Werkstückmaterial unter Einsatz eines Ätzmittels von dem Werkstück entfernt wird.

Ferner betrifft die Erfindung ein System zum Ausbilden einer Struktur in einem Werkstück durch selektives Laserätzen.

Selektives Laserätzen (auch: "Selective Laser Etching, SLE") ist ein etabliertes Verfahren zur 3D-Strukturierung von Werkstücken wie Gläsern durch eine zweistufige Prozessfolge. Weitere übliche Bezeichnungen zum selektiven Laserätzen sind ISLE ("In-Volume Selective Laser Etching) und FLICE ("femtosecond laser irradiation followed by chemical etching").

In einem ersten Schritt wird Werkstückmaterial in einem Volumenelement eines für Laserstrahlung transparenten (hiermit kann auch eine teilweise Absorption von Laserstrahlung gemeint sein) Werkstücks mit Laserstrahlung in Kontakt gebracht. Dabei wird gepulste Laserstrahlung (vornehmlich fs-Laserpulse und ps-Laserpulse im Infrarotbereich oder UV-Bereich, dies kann auch bei der vorliegenden Erfindung der Fall sein) in dem transparenten Werkstück fokussiert. Aus der Laserbestrahlung resultiert im Fokusbereich eine strukturelle Modifikation des Werkstückmaterials. Diese strukturelle Modifikation erfolgt durch Absorption der Laserstrahlung im Werkstück, vornehmlich durch eine sogenannte Multiphotonenabsopriton. Da hierzu hohe Intensitäten erforderlich sind, eignen sich insbesondere Ultrakurzpulslaser für diesen Schritt (so auch vorzugsweise bei der vorliegenden Erfindung der Fall). Diese Modifikation ändert das chemische Ätzverhalten des Werkstückmaterials, was als "Selektivität" bezeichnet wird, d.h. dem Verhältnis einer Ätzrate von unmodifizierten Werkstückmaterial zu einer Ätzrate von modifizierten Werkstückmaterial. Die Selektivität ist abhängig vom Werkstückmaterial, Ätzmittel, Temperatur und Konzentration des Ätzmittels, Umgebungsbedingungen (z.B. mechanische Anregung/Bewegung des Werkstücks und Ätzmittels durch Ultraschall) aber auch dem Laserprozess (Betriebsparametern, Laserparameter, Bearbeitungsparameter) und nimmt Werte von typischerweise 10 bis 1000 ein.

In einem zweiten Schritt erfolgt nach der strukturellen Modifizierung von Werkstückmaterial mit Laserstrahlung eine Ätzbearbeitung, wobei das laserbearbeitete Werkstück mit einem Ätzmittel beaufschlagt wird. In der Regel wird das zu bearbeitende Werkstück dazu in einem Ätzbad platziert. Gegebenenfalls wird zusätzlich ein Ultraschallgerät verwendet, um einen verbesserten Austausch des Ätzmittels zu gewährleisten. Beim Ätzen wird das gesamte Werkstück geätzt, allerdings wird durch die stark unterschiedliche Selektivität der vorab mittels Laserstrahlung modifizierte Bereich um den Faktor 10-1000 stärker/schneller geätzt als unmodifizierte Bereiche des Werkstücks. Nach einer typischerweise mehrstündigen Verweilzeit des Werkstücks im Ätzbad, sind in dem Werkstück beispielsweise 3D-Geometrien (z.B. Kanäle) erzeugbar.

Nachteilig bei diesem Verfahren ist neben der langen Ätzdauer vor allem das begrenzte Aspektverhältnis, bei einem Kanal also das Verhältnis von Kanaldurchmesser zu Kanallänge. Sofern lange Kanäle in dem Werkstück auf diesem Wege ausgebildet werden sollen, so muss ein langer Kanal für eine relativ lange Zeit geätzt werden, damit das Ätzmittel ihn vollständig durchdringt. Da jene nicht lasermodifizierten Bereiche des Werkstücks in dieser Zeit ebenfalls geätzt werden, entstehen so trotz stark unterschiedlicher Selektivität bei großen Kanallängen/Aspektverhältnissen ungewünschte Überätzungen. Ein entlang einer geraden Linie modifizierter Kanal wird so konisch, da das Ätzmittel nach und nach den Eingangsbereich des Kanals aufätzt.

Zusammenfassend lässt sich festhalten, dass beim selektiven Laserätzen ein für die verwendete Laserstrahlung transparentes Werkstückmaterial mittels eines oder mehrerer ultrakurzer Laserpulse, in deren Fokus nichtlinear induzierte Absorptionsvorgänge, beispielsweise Multiphotonenabsorptionen stattfinden, modifiziert wird. Dabei werden die chemischen und/oder physikalischen Eigenschaften des Werkstückmaterials so modifiziert, dass das Material besser ätzbar wird. In einem nachfolgenden Schritt wird dann mit einem Ätzverfahren das modifizierte Material selektiv entfernt.

Aus der DE 10 2019 200 750 A1 ist ein Verfahren zum Laserätzen bekannt, bei dem vor der Ausbildung einer Struktur (einer Hohlraumstruktur innerhalb des Werkstücks in Form von Kanälen) in einem Werkstück durch Laserätzen, vorab Hilfszugänge in das Werkstück eingebracht werden. Durch diese Hilfszugänge kann das Ätzmittel einfacher zu jenen durch Laserstrahlung strukturell modifizierten Bereichen gelangen. Ein solches Verfahren bedarf einem hohen Maß an Konstruktionsplanung und limitiert das Design der auszubildenden Struktur. Denn die erforderlichen Hilfszugänge verbleiben im Werkstück oder müssen im Nachgang verschlossen werden.

Der vorliegenden Erfindung liegt daher die Aufgabe zugrunde ein verbessertes Verfahren und System vorzuschlagen, mit welchem die Erzeugung von Strukturen in einem Werkstück mit einem hohen Maß an Flexibiltät ohne Überätzungen oder nur mit einem geringen Maß an Überätzungen ermöglicht wird.

Die genannte Aufgabe wird mit einem Verfahren gemäß dem Anspruch 1 sowie einem System, gemäß dem Anspruch 28 gelöst.

Es sei bemerkt, dass sämtliche im Zusammenhang des beanspruchten und beschriebenen Verfahrens genannten Merkmale auch Ausgestaltungen des beanspruchten und beschriebenen Systems sein können und umgekehrt.

Es sei ferner bemerkt, dass jegliche Konjunktion "und/oder" zwischen zwei Merkmalen so zu verstehen ist, dass in einer Ausgestaltung entweder das eine oder das andere Merkmal vorgesehen ist, oder aber, dass beide Merkmale vorliegen (und-Verknüpfung).

Die Erfindung betrifft zunächst ein Verfahren zum Ausbilden einer Struktur in einem Werkstück durch selektives Laserätzen, wobei
a) Werkstückmaterial des Werkstücks in einem zu der auszubildenden Struktur korrespondierenden Werkstück-Bearbeitungsbereich des Werkstücks durch Laserstrahlung strukturell modifiziert wird; und wobei
b) das modifizierte Werkstückmaterial unter Einsatz eines Ätzmittels von dem Werkstück entfernt wird.

Das Verfahren zeichnet sich dadurch aus, dass zum Entfernen des modifizierten Werkstückmaterials eine von einer Ätzvorrichtung erzeugte Ätzmittelfront entlang des Werkstück-Bearbeitungsbereichs geführt wird. Grundsätzlich können mit dem Verfahren Oberflächenstrukturen oder in-Volumenstrukturen (z. B. Hohlraumstrukturen) in dem Werkstück ausgebildet werden.

Unter einem "Werkstück" kann ein mittels selektivem Laserätzen zu bearbeitender (dreidimensionaler) Körper verstanden werden, der aus einem Werkstückmaterial gebildet ist. Das Werkstück kann unterschiedlichste Geometrien annehmen und ist nicht auf eine bestimmte Geometrie festgelegt.

Unter einer "Struktur" kann eine gewünschte bzw. zu erzielende Struktur in dem Werkstück verstanden werden. Bei der Struktur kann es sich um eine Oberflächenstruktur oder eine innerhalb des Werkstücks (also innerhalb eines Vollkörpermaterials des Werkstücks) ausgebildete Struktur handeln. Typische Strukturen, die innerhalb des Werkstücks ausgebildet werden, betreffen Hohlraumstrukturen wie Kanäle oder Kavitäten. Die Strukturen können Teilstrukturen aufweisen, die separiert vorliegen oder zusammenhängend sein können. Als Beispiel für eine zusammenhängende Struktur sei ein aus mehreren zusammenhängenden Kanälen gebildetes Kanalsystem genannt. Ein und dasselbe Werkstück kann sowohl eine Oberflächenstruktur als auch eine Hohlraumstruktur aufweisen. Oberflächenstrukturen können beispielsweise Bohrungen, Löcher, Nuten, Schlitze oder dergleichen sein.

Die zum strukturellen Modifizieren eingesetzte Laserstrahlung wird vorzugsweise durch einen Ultrakurzpulslaser bereitgestellt bzw. erzeugt. Dabei wird für die Laserstrahlung vorzugsweise eine Wellenlänge verwendet, für die das Werkstück transparent oder zumindest teilweise transparent ist. Transparenz meint an dieser Stelle, dass die Laserstrahlung von dem Werkstückmaterial nicht diffus gestreut wird, sodass ein Laserstrahl im Medium weitestgehend seine Propagationsrichtung beibehält. Gleichwohl kann das Werkstückmaterial Laserstrahlung (zumindest teilweise) absorbieren, wodurch eine Abnahme der Laserleistung resultieren kann. Entsprechende (nichtlineare) Absorptionsprozesse wie Multiphotonenabsorption macht sich das Verfahren zur strukturellen Modifizierung des Werkstückmaterials zu Nutze.

Unter einer "strukturellen Modifikation" ist insbesondere zu verstehen, dass in jenen durch Einwirkung von Laserstrahlung strukturell modifizierten Werkstück-Bearbeitungsbereichen im Vergleich zu nicht mit Laserstrahlung beaufschlagten Werkstück-Bereichen, Werkstückmaterial unter Verwendung eines Ätzmittels mit einer höheren Ätzrate (d.h. schneller) entfernt werden kann. Somit meint eine "strukturelle Modifikation" insbesondere eine Änderung des chemischen Ätzverhaltens des Werkstückmaterials (Ätzselektivität) durch Änderung der Materialstruktur, chemischen Eigenschaften oder Materialtopografie, was allesamt aus der Laserbearbeitung resultiert.

Aktuell existiert noch keine einheitliche Theorie über die beim selektiven Laserätzen durch die Einwirkung von Laserstrahlung ablaufenden (mikroskopischen) Prozesse, die zur "strukturellen Modifizierung" des Werkstückmaterials und somit zu den erwähnten höheren Ätzraten führen. Handelt es sich bei dem Werkstück um ein Glas mit einem Glasnetzwerk aus SiO₄ Tetraedern, so lassen sich in Folge der Einwirkung von Laserstrahlung reduzierte Winkel der SiO₄ Tetraeder beobachten, welche die Reaktivität des Sauerstoffs aufgrund einer verformten Valenzelektronenanordnung erhöhen. Das Glasnetzwerk besteht aus SiO₄ Tetraedern, die in unregelmäßigen Ringen ein Netzwerk aus einer Anzahl von 2 bis 6 Si-Atomen, verbunden über jeweils ein O-Atom, bilden, wobei eine Anzahl von 5 bis 6 Si-Atomen pro Ringstruktur am häufigsten erwartet wird. Es wird angenommen, dass die Reduktion der Si-O-Si Winkel auf eine Reduktion der Si-Atomanzahl pro Ringstruktur zurückzuführen ist. Mit Laserstrahlung modifizierte Bereiche weisen einen erhöhten Anteil an Ringen mit einer Anzahl von drei Si-Atomen pro Ring auf, was einem dichteren und instabileren Netzwerk entspricht und dadurch leichter geätzt werden kann.

Unter einer "Entfernung" von modifiziertem Werkstückmaterial durch das Ätzmittel ist zu verstehen, dass das strukturell modifizierte Werkstückmaterial von dem Werkstück gelöst/abgelöst/abgetragen wird. Ein "Ätzmittel" ist eine Substanz, insbesondere in flüssiger Form, mit der das strukturell modifizierte Werkstückmaterial von dem Werkstück lösbar/ablösbar/abtragbar ist.

Eine "Ätzmittelfront" ist ein geometrisch begrenzter Bereich, in welchem Ätzmittel in Kontakt mit dem strukturell modifizierten Werkstückmaterial gelangt und dieses dort entfernt. An der Ätzmittelfront ist im Unterschied zu bekannten Verfahren (Ätzbäder) die Konzentration an Ätzmittel lokal erhöht, da stetig frisches (und ggf. hochkonzentriertes) Ätzmittel zugeführt werden kann. Dadurch kann die Ätzrate signifikant erhöht werden. Das im Rahmen der hiesigen Erfindung beschriebene Verfahren kann sich zusätzlich die Wirkung von Ultraschallwellen zu Nutze machen, womit der Austausch des Ätzmittels an der Bearbeitungsfront und damit die Ätzrate gesteigert werden kann. Ultraschallwellen können das Abtragen von strukturell modifiziertem Werkstückmaterial durch das Ätzmittel in Form von Schockwellen mechanisch unterstützen oder verstärken.

Der "Werkstück-Bearbeitungsbereich" korrespondiert - wie erwähnt - zu der im Werkstück auszubildenden Struktur und kann insbesondere vor der dem strukturellen Modifizieren mit Laserstrahlung von einem Nutzer festgelegt werden. Der Werkstück-Bearbeitungsbereich legt jenen Bereich des Werkstücks fest, der mittels Laserstrahlung strukturell modifiziert wird, und in welchem das strukturell modifizierte Werkstückmaterial mittels der Ätzvorrichtung entfernt wird. In jenen außerhalb des vorgegebenen Werkstück-Bearbeitungsbereichs vorliegenden Bereichen des Werkstücks erfolgt weder eine strukturelle Modifizierung von Werkstückmaterial noch (im Gegensatz zum Stand der Technik) eine Entfernung von Werkstückmaterial durch Ätzmittel. Denn gemäß der vorliegenden Erfindung wird die von der Ätzvorrichtung erzeugte Ätzmittelfront räumlich selektiv ausschließlich entlang des Werkstück-Bearbeitungsbereichs geführt, sodass ein ungewünschter Materialabtrag von außerhalb dieses Werkstück-Bearbeitungsbereichs liegenden Werkstückbereichen vermieden wird. Bei der aus dem Stand der Technik bekannten Ätzbehandlung von Werkstücken in Ätzbädern, gelangen auch jene außerhalb der eigentlichen (auszubildenden) Struktur liegenden Werkstückbereiche in Kontakt mit dem Ätzmittel, sodass auch in den dortigen Bereichen (zwar unter geringerer Ätzrate) Werkstückmaterial abgetragen wird.

Bei dem erfindungsgemäßen Verfahren erfolgt die Kontaktierung des Werkstücks mit Ätzmittel also ausschließlich in einem lokal begrenzten Bereich (Stichwort: entlang des Werkstück-Bearbeitungsbereichs geführte Ätzmittelfront). Abschnitte des Werkstück-Bearbeitungsbereichs die mittels Laserstrahlung bereits strukturell modifiziert und in denen im Anschluss mit dem Ätzmittel Werkstückmaterial entfernt wurde (also jene Bereiche des Werkstück-Bearbeitungsbereichs, an denen die Ätzmittelfront bereits vorbeigeführt wurde) werden nicht mehr weiter geätzt (im Gegensatz zu den aus dem Stand der Technik bekannten Ätzbädern).

Mit der vorliegenden Erfindung (Verfahren und System) ist es möglich, makroskopische Strukturen mit Auflösungen im Bereich > 10 µm im Werkstück auszubilden. Typische (mit der Erfindung zugängliche) Strukturgrößen der auszubildenden Struktur liegen im Bereich von mehreren hundert Mikrometern bis Millimetern liegen. Beispielsweise können Kanäle mit Durchmessern mindestens 2 mm oder größer (beispielsweise 10 mm), oder noch größer mit einem Verfahren nach der Erfindung ausgebildet werden. Kanallängen können beispielsweise im Bereich von bis zu 500 mm liegen. Insbesondere können lange Kanalstrukturen in dem Werkstück ausgebildet werden, die ein Aspektverhältnis (Kanaldurchmesser zu Kanallänge) von 1: 100 bis 1:1000 erzielen können. Im Stand der Technik sind im Gegensatz dazu vornehmlich Applikationen von selektivem Laserätzen für besonders kleine Strukturen und hohe Auflösungen beschrieben, was häufig als Mikro-SLE bezeichnet wird (typische Auflösungen im Bereich 1 µm).

Weitere vorteilhafte Ausgestaltungen der Erfindung sind in den Unteransprüchen und in der nachfolgenden Beschreibung der in den Unteransprüchen angegebenen Merkmale wiedergegeben.

Nach einer ersten Ausgestaltung der Erfindung kann vorgesehen sein, dass
a) das strukturelle Modifizieren von Werkstückmaterial des Werkstücks in dem zu der auszubildenden Struktur korrespondierenden Werkstück-Bearbeitungsbereich des Werkstücks durch Laserstrahlung;
   und
b) das Entfernen des modifizierten Werkstückmaterials unter Einsatz des Ätzmittels von dem Werkstück;

im Wesentlichen zeitgleich oder sequenziell ausgeführt werden.

Im Wesentlichen zeitgleich kann dabei bedeuten, dass beide Prozesse parallel ablaufen. Dies kann beispielsweise eine zeitgleich ablaufende strukturelle Modifizierung und Entfernung von Werkstückmaterial an unterschiedlichen Stellen des Werkstück-Bearbeitungsbereichs bedeuten, jedoch auch eine in etwa zeitgleiche (bzw. unmittelbar nacheinander ausgeführte) strukturelle Modifizierung und Entfernung von Werkstückmaterial an ein und derselben Stelle des Werkstück-Bearbeitungsbereichs (beispielsweise kann dazu die Ätzmittelfront einem oder mehreren Laserstrahlen unmittelbar nachgeführt werden). Auch eine exakt zeitgleiche strukturelle Modifizierung und Entfernung von Werkstückmaterial an einer Stelle des Werkstück-Bearbeitungsbereichs ist grundsätzlich denkbar. Eine sequenzielle Ausführung der genannten Prozessschritte a) und b) meint, dass die Prozessschritte im Sinne einer Schrittfolge nacheinander ausgeführt werden. Dies bedeutet, dass ein Werkstück-Bearbeitungsbereich zunächst mittels Laserstrahlung strukturell modifiziert wird und sodann (also zeitlich nachgelagert und in einem zeitlichen Abstand) das strukturell modifizierte Werkstückmaterial mittels des Ätzmittels (also durch Führen der Ätzmittelfront entlang des Werkstück-Bearbeitungsbereichs) entfernt wird. In der Zwischenzeit zwischen den genannten Bearbeitungsschritten können das Werkstück und/oder Maschinenkomponenten (z. B. eine Laserbearbeitungsvorrichtung, die Ätzvorrichtung) positioniert werden. Beispielsweise kann eine zunächst in einer Bearbeitungsposition befindliche Laserbearbeitungsvorrichtung in eine Nicht-Bearbeitungsposition (Parkposition) verbracht werden. Die Ätzvorrichtung kann derweil von einer Nicht-Bearbeitungsposition (Parkposition) in eine Bearbeitungsposition verbracht werden. Gleichsam kann das Werkstück relativ zu den genannten Vorrichtungen positioniert werden. Als besonders vorteilhaft hat sich erwiesen, dass die Laserbearbeitungsvorrichtung und die Ätzvorrichtung separate Maschinen sind. Diese (separaten) Maschinen können steuer- und regelungstechnisch miteinander verknüpft sein.

Nach einer weiteren Ausgestaltung der Erfindung kann vorgesehen sein, dass das Werkstück aus Glas gefertigt ist, insbesondere aus Glaskeramik (z. B. Zerodur), Quarzglas, Borosilikatglas, metallischem Glas wie Titanium-Silikatglas (SiOz-TiOz-Glas), oder Saphir. Das Werkstück kann auch ein metalldotiertes Glas, beispielsweise titandotiertes Quarzglas sein. Auch kann das Werkstück aus Kunststoff gefertigt sein, beispielsweise aus einem Kunststoffglas wie Acrylglas, Plexiglas etc. Auch kann das Werkstück aus einem Verbundwerkstoff gefertigt sein. Das Werkstück kann zudem eine mehrlagige Struktur aus unterschiedlichen Materialien umfassen. Es sei betont, dass das Werkstück nebst den genannten Materialien noch weitere Materialien umfassen kann. Die vorgenannten Materialien wie Glas, Glaskeramik, Quarzglas, Borosilikatglas, metallisches Glas, metalldotiertes Glas (z. B. titandotiertes Quarzglas), Saphir, Kunststoff, Kunststoffglas etc. können sich auch nur auf den Werkstück-Bearbeitungsbereich beziehen. Dies kann bedeuten, dass das Werkstück in einem Bereich, in dem eine Struktur ausgebildet werden soll, aus einem der genannten Materialien gefertigt ist, in anderen Bereichen (die keiner Bearbeitung unterzogen werden sollen) aber aus einem anderweitigen Material gefertigt sein kann.

Nach einer weiteren Ausgestaltung der Erfindung kann vorgesehen sein, dass zur Modifizierung des Werkstückmaterials ein Laserstrahl oder mehrere Laserstrahlen in dem Werkstück-Bearbeitungsbereich des Werkstücks fokussiert werden und die zur strukturellen Modifizierung eingesetzte Laserstrahlung bereitstellen. Der Laserstrahl oder die mehreren Laserstrahlen können durch eine oder mehrere Laserbearbeitungsvorrichtung(en) bereitgestellt werden, welche die jeweiligen Laserstrahlen erzeugen. Dabei handelt es sich vorzugsweise um Ultrakurzpulslaserbearbeitungsvorrichtungen. Mehrere Laserstrahlen können auch durch eine einzelne Laserbearbeitungsvorrichtung (z. B. Ultrakurzpulslaserbearbeitungsvorrichtung) bereitgestellt werden, die aus einem von einer Laserstrahlungsquelle erzeugten Laserstrahl eine Mehrzahl von Teilstrahlen erzeugt.

Nach einer weiteren Ausgestaltung der Erfindung kann vorgesehen sein, dass das Werkstückmaterial zumindest in dem Werkstück-Bearbeitungsbereich transparent für die eingesetzte Laserstrahlung ist. Wie erwähnt, meint "Transparenz" an dieser Stelle, dass die Laserstrahlung von dem Werkstückmaterial nicht diffus gestreut wird. Gleichwohl kann das Werkstückmaterial Laserstrahlung (zumindest teilweise) absorbieren, woraus eine Abnahme der Laserleistung resultieren kann. Entsprechende (nichtlineare) Absorptionsprozesse wie Multiphotonenabsorption macht sich das Verfahren zur strukturellen Modifizierung des Werkstückmaterials zu Nutze. Zu beachten ist, dass im Wege der Laserbearbeitung (also der strukturellen Modifizierung des Werkstückmaterials) kein Materialabtrag erfolgt, sondern erst durch den Einsatz des Ätzmittels.

Nach einer weiteren Ausgestaltung der Erfindung kann vorgesehen sein, dass zur strukturellen Modifizierung des Werkstückmaterials in dem Werkstück-Bearbeitungsbereich eine Relativbewegung zwischen dem Laserstrahl oder den mehreren Laserstrahlen und dem Werkstück bereitgestellt wird, nämlich durch
a. Bewegen des Laserstrahls oder der mehreren Laserstrahlen relativ zu dem Werkstück, während das Werkstück positionsfest ist;
b. Bewegen des Werkstücks relativ zu dem Laserstrahl oder den mehreren Laserstrahlen, wobei der Laserstrahl oder die mehreren Laserstrahlen positionsfest sind; oder
c. Bewegen des Laserstrahls oder der mehreren Laserstrahlen relativ zu dem Werkstück sowie Bewegen des Werkstücks relativ zu dem Laserstrahl oder den mehreren Laserstrahlen.

Eine Werkstückbewegung kann durch eine zur Ausführung von Bewegungen ausgebildete Werkstückaufnahme bereitgestellt werden. Eine solche Werkstückaufnahme kann Mittel zum Befestigen/Halten/Positionieren des Werkstücks aufweisen, jedoch auch Bewegungsmittel wie eine zwei- oder dreidimensional bewegliche Bewegungseinheit. Die Werkstückaufnahme kann im einfachsten Fall in Form einer Auflageplatte bzw. eines Tischs ausgebildet sein, auf welchem das Werkstück gewichtskraftbasiert positioniert werden kann. Bei der Werkstückaufnahme kann es sich beispielsweise um einen xy/xyz-Tisch handeln, welcher in einer Ebene oder dreidimensional bewegbar ist.

Eine zweidimensional bewegliche Bewegungseinheit kann das Werkstück insbesondere innerhalb einer zweidimensionalen Ebene bewegen, während eine dreidimensional bewegliche Bewegungseinheit zusätzlich auch Bewegungen senkrecht zu einer solchen zweidimensionalen Ebene ausführen kann. Eine Bewegungseinheit kann über eine entsprechende Bewegungsmechanik und eine geeignete Antriebseinheit verfügen.

Zur Bewegung des Laserstrahls oder der mehreren Laserstrahlen können ein oder mehrere Galvanometerscanner eingesetzt werden. Galvanometerscanner sind aus dem Stand der Technik bekannt. Die genannten Bewegungseinheiten und/oder Galvanometerscanner können von einer Steuereinheit gesteuert werden, dabei unter Berücksichtigung der Geometrie der auszubildenden Struktur. Dabei können entsprechende Bewegungspfade oder Bewegungsmuster vorab ermittelt werden. Die Steuereinheit steuert die Bewegungseinheiten und/oder Galvanometerscanner entsprechend den ermittelten Bewegungspfaden oder Bewegungsmustern. Bewegungseinheiten und Galvanometerscanner können von der Steuereinheit synchronisiert betrieben werden. Auch können den Bewegungseinheiten und einem Galvanometerscannern Sub-Steuereinheiten zugeordnet sein, wobei diese Sub-Steuereinheiten von einer übergeordneten Steuereinheit synchronisiert werden können. Eine positionsfeste Anordnung des Werkstücks kann durch eine Werkstückaufnahme gewährleistet werden, welche das Werkstück einerseits nicht bewegt und andererseits mit Fixiermitteln fixiert.

Nach einer weiteren Ausgestaltung der Erfindung kann vorgesehen sein, dass die in dem Werkstück auszubildende Struktur eine Hohlraumstruktur ist, wobei zur Ausbildung der Hohlraumstruktur ein wandernder Ätzraum entlang des Werkstück-Bearbeitungsbereichs in das Werkstück eingetrieben wird, nämlich durch Eintreiben eines Ätzvorrichtungskopfes der Ätzvorrichtung samt einer von diesem erzeugten Ätzmittelfront in das Werkstück entlang des Werkstück-Bearbeitungsbereichs unter gleichzeitiger Ausbildung des wandernden Ätzraums und eines die Hohlraumstruktur ausbildenden, rückwärtig zum Ätzraum angeordneten Hohlraums, wobei die Ätzmittelfront während des Eintreibens modifiziertes Werkstückmaterial von einer wandernden Bearbeitungsfront löst. Beim Eintreiben des wandernden Ätzraums in das Werkstück wird der Ätzvorrichtungskopf sukzessive entlang des Werkstück-Bearbeitungsbereichs vorgeschoben, ggf. unter Einsatz einer Vorschub-Antriebseinheit. Dies kann von außerhalb des Werkstücks erfolgen, gleichsam aber auch erst nach Einführen des Ätzvorrichtungskopfes und der Ätzvorrichtung in einen vorab ausgebildeten Hohlraum oder Kanal im Werkstück (beispielsweise zur Ausbildung von Seitenkanälen).

Unter einem "wandernden Ätzraum" ist ein abgegrenzter Raum (mit einem Raumvolumen) zwischen Ätzvorrichtungskopf und Bearbeitungsfront zu verstehen. Vorzugsweise gelangt Ätzmittel lediglich in diesem Ätzraum in Kontakt mit dem Werkstückmaterial, nicht jedoch im rückwärtig zum Ätzraum angeordnetem Hohlraum. Auch gelöstes Werkstückmaterial gelangt vorzugsweise nicht in Kontakt mit dem Wandungen des rückwärtig zum Ätzraum angeordneten Hohlraums, sondern wird vorzugsweise aus dem Ätzraum durch die Ätzvorrichtung nach Werkstück-außen befördert. Bei Eintreiben einer Hohlraumstruktur (wie einer Kanalstruktur) in ein Werkstück ist zu verstehen, dass ein gebildeter Hohlraum vormals ebenfalls Teil eines Ätzraums war. Durch Vortreiben bzw. Vorschieben der Ätzmittelfront und des Ätzvorrichtungskopfes wandert der Ätzraum entlang des Werkstück-Bearbeitungsbereichs und bildet nach und nach den (in seinem Gesamtvolumen zunehmenden) Hohlraum aus. Rückwärtig zu dem wandernden Ätzraum bildet sich der Hohlraum, dessen Volumen sich mit Vortreiben des Ätzraums stetig vergrößert. Der Ätzraum kann eine Querschittsgeometrie aufweisen, die der Querschnittsgeometrie der auszubildenden Struktur in dem Werkstück entspricht. Die Querschnittsgeometrie des Ätzraums hängt maßgeblich von der Geometrie der Ätzmittelfront ab, da sich diese nach und nach in das Werkstück "eingräbt" bzw. in das Werkstück getrieben wird.

Nach einer weiteren Ausgestaltung der Erfindung kann vorgesehen sein, dass die wandernde Bearbeitungsfront ein wanderndes Ende des Ätzraums bereitstellt. Das "wandernde" Ende der Bearbeitungsfront ist durch den Prozess des sukzessiven Eintreibens des Ätzraums in das Werkstück begründet. Es erklärt sich von selbst, dass bei einem wandernden Ätzraum auch die Bearbeitungsfront und die dort applizierte Ätzmittelfront mitwandert. Die Geschwindigkeit des "Wanderns" hängt insbesondere von einer durch die Vorschub-Antriebseinheit bereitgestellte Vorschubgeschwindigkeit des Ätzvorrichtungskopfes und der Ätzrate ab.

Nach einer weiteren Ausgestaltung der Erfindung kann vorgesehen sein, dass der wandernde Ätzraum zwischen dem Ätzvorrichtungskopf und der wandernden Bearbeitungsfront angeordnet ist. Insoweit kann der wandernde Ätzraum trotz seines "Wanderns" durch das Werkstück einen in sich abgeschlossenen Raum bildet. Idealerweise gelangt das Ätzmittel ausschließlich in diesem Raum in Kontakt mit dem Werkstückmaterial. Im Bereich des Ätzvorrichtungskopfes können Maßnahmen zum Abdichten des Ätzraums in Richtung des rückwärtig des Ätzraums gebildeten Hohlraums vorgesehen sein, sodass ein Rückfluss von Ätzmittel in den Hohlraum vermieden werden kann. Ferner wird der Ätzraum durch die Bearbeitungsfront und Wandungen des Ätzraums (aus Werkstückmaterial) begrenzt.

Nach einer weiteren Ausgestaltung der Erfindung kann vorgesehen sein, dass das gelöste modifizierte Werkstückmaterial mittels der Ätzvorrichtung, aus dem Ätzraum nach Werkstück-außen befördert wird. Dazu kann die Ätzvorrichtung geeignete Beförderungsmittel aufweisen, die eine solche Beförderung des vom Werkstück entfernten bzw. gelösten modifizierten Werkstückmaterials ermöglicht. Beispielsweise kann das entfernte bzw. gelöste Werkstückmaterial mit dem Ätzmittel in Richtung nach Werkstück-außen befördert werden. Gegebenenfalls kann sich dort eine Abtrennung (z. B. Filtern, Sieben, Fällen, Zentrifugieren, Dekantieren, Absetzen etc.) des entfernten bzw. gelösten Werkstückmaterials vom Ätzmittel sowie Regenerierung des Ätzmittels anschließen. Regeneriertes Ätzmittel kann erneut durch die Ätzvorrichtung in Richtung der Ätzmittelfront befördert werden. Eine "Beförderung" kann beispielsweise ein Pumpen sein.

Nach einer weiteren Ausgestaltung der Erfindung kann vorgesehen sein, dass als Ätzmittel eine Säure oder Lauge verwendet wird, wobei insbesondere Flusssäure, Salzsäure, Salpetersäure, Schwefelsäure, Königswasser, Kalilauge, Natronlauge, Lithiumlauge, Ammoniaklösung verwendet werden kann. Auch eine Verwendung von mineralischen Säuren oder Basen, metallischen Säuren oder Basen oder einem Ätzschaum ist vorstellbar. Nicht zwingend muss das Ätzmittel eine Säure oder Lauge sein. Vorstellbar ist auch die Verwendung eines neutralen Ätzmittels. Auch N-Methyl-2-Pyrrolidon, ein entsprechendes Derivat oder eine Mischung mit anderen Stoffen kann als Ätzmittel eingesetzt werden. Auch Mischungen aus den vorgenannten Stoffen können zur Bereitstellung des Ätzmittels verwendet werden. Je nach Werkstückmaterial kann die Verwendung eines bestimmten Ätzmittels vorteilhaft sein. Die genannte Liste ist nicht abschließend zu verstehen.

Nach einer weiteren Ausgestaltung der Erfindung kann vorgesehen sein, dass die Ätzeigenschaften des Ätzmittels eingestellt werden, insbesondere über: die Art des Ätzmittels, die Konzentration des Ätzmittels, die Temperatur des Ätzmittels, und/oder die Verweilzeit des Ätzmittels an der wandernden Bearbeitungsfront. In Abhängigkeit des zu ätzenden Werkstückmaterials kann ein bestimmtes Ätzmittel besonders gute Ätzeigenschaften für ein bestimmtes Werkstückmaterial aufweisen oder nicht. Gleiches gilt für die Konzentration, Temperatur und Verweilzeit des Ätzmittels an der Bearbeitungsfront. So kann für ein bestimmtes Werkstückmaterial ein Optimum hinsichtlich der besagten Parameter existieren, dessen Nutzung vorteilhaft für einen effizienten Ätzvorgang ist. Bei der Verweilzeit des Ätzmittels an der Bearbeitungsfront ist zu beachten, dass eine besonders lange Verweilzeit die Effizienz des Ätzvorgangs nicht zwingend steigert. Zwar mag eine längere Verweilzeit vorteilhaft für eine tiefgehende Einwirkung des Ätzmittels in das Werkstückmaterial sein, möglicherweise stellen sich aber nach einer gewissen Zeit nachteilige Sättigungseffekte ein. Entsprechend kann auch eine kurze Verweilzeit vorteilhaft sein, wodurch stets eine kurze Kontaktzeit der Bearbeitungsfront mit stets "frischem" Ätzmittel gewährleistet wird.

Nach einer vorteilhaften Ausgestaltung der Erfindung kann vorgesehen sein, dass das modifizierte Werkstückmaterial mit einer konstanten Ätzrate (bzw. konstanten Ätzselektivität) von dem Werkstück entfernt wird. Insbesondere kann es - unabhängig davon, ob eine lange oder kurze Verweilzeit (Kontaktzeit) des Ätzmittels an der Bearbeitungsfront eingestellt wird - vorteilhaft sein, im Ätzraum (bzw. an der Bearbeitungsfront) eine konstante Temperatur, eine konstante Konzentration des Ätzmittels und (bei zusätzlicher Verwendung von Ultraschall) eine konstante Ultraschallleistung bereitzustellen. Dadurch kann die Ätzrate (bzw. Ätzselektivität) konstant gehalten werden, was vorteilhaft für einen homogenen Abtrag von Werkstückmaterial ist. Ein konstant-Halten der Ätzrate (Ätzselektivität) kann - bezogen auf die Ätzrate (bzw. Ätzselektivität) - als einstufiges Ätzen verstanden werden. Die Ätzrate (bzw. Ätzselektivität) kann unter Einsatz von einer oder mehreren geeigneten Messeinheiten, beispielsweise einer Optrode, (Messeinheiten können im Bereich des Ätzvorrichtungskopfes angeordnet sein und sind an mehreren Stellen der Anmeldung beschrieben) eingestellt werden (z. B. durch Messen, Überwachen und Einstellen der Konzentration des Ätzmittels im Ätzraum).

Nach einer weiteren Ausgestaltung der Erfindung kann vorgesehen sein, dass das modifizierte Werkstückmaterial in mehreren sequenziell durchgeführten Ätzschritten unter Variation der Art des Ätzmittels, der Konzentration des Ätzmittels, der Temperatur des Ätzmittels und/oder der Verweilzeit des Ätzmittels an der wandernden Bearbeitungsfront von dem Werkstück entfernt wird. Hierbei ist vorstellbar, dass zunächst eine Grobätzung vorgenommen wird, an welche sich sodann eine Feinätzung anschließen kann. Für die Grob- und Feinätzung können unterschiedliche Ätzmittel oder unterschiedliche Konzentrationen des Ätzmittels gewählt werden. Gleiches gilt für die Temperatur und/oder die Verweilzeit des Ätzmittels. Auch kann vorgesehen sein, beim Grobätzen ein anderes lokales Konzentrationsprofil der Ätzmittelfront bereitzustellen als beim Feinätzen. Ferner können beim Grobätzen gänzlich andere Profilformen der Ätzmittelfront gewählt werden als beim Feinätzen.

Alternativ kann auch ein (nacheinander durchgeführter) mehrstufiger Ätzvorgang (z. B. beim mehrmaligen Ein- und Ausführen der Ätzvorrichtung in einen Kanal oder beim Wechsel des Ätzvorrichtungskopfes) unter Gewährleistung einer konstanten Ätzselektivität durchgeführt werden. Hierzu kann beispielsweise gewährleistet werden, dass im Ätzraum (bzw. an der Bearbeitungsfront) konstante Arbeitsbedingungen vorliegen, z. B. betreffend eine konstante Temperatur, konstante Ätzmittelkonzentration, konstante Ultraschallleistung etc. Auch ein konstant-Halten von Umgebungsbedingungen (Druck, Luftfeuchtigkeit, Strahlung etc.) kann diesbezüglich vorteilhaft sein.

Nach einer weiteren Ausgestaltung der Erfindung kann vorgesehen sein, dass die Ätzvorrichtung eine Zuleitungsvorrichtung zum Zuleiten des Ätzmittels in den Ätzraum und somit in Richtung der wandernden Bearbeitungsfront umfasst, und ferner eine Ableitungsvorrichtung zum Ableiten des Ätzmittels sowie gelöstem modifizierten Werkstückmaterial aus dem Ätzraum umfasst. Die Zuleitungsvorrichtung und die Ableitungsvorrichtung können in dem erwähnten Ätzvorrichtungskopf in die Ätzkammer münden.

Der Ätzvorrichtungskopf kann entsprechende Zuleitungs- und Ableitungsregulierungsmittel (z. B. Ventile) aufweisen, um eine kontrollierte Zu- und Ableitung zu gewährleisten.

Nach einer weiteren Ausgestaltung der Erfindung kann vorgesehen sein, dass die Zuleitungsvorrichtung einen Zuleitungskanal, insbesondere einen Zuleitungsschlauch, umfasst, und wobei die Ableitungsvorrichtung ein Ableitungskanal, insbesondere einen Ableitungsschlauch, umfasst. Bei dem Zuleitungskanal und dem Ableitungskanal handelt es sich vorzugsweise um getrennte Kanäle. Im Falle einer Ausbildung des Zuleitungsvorrichtung als Zuleitungsschlauch und einer Ausbildung der Ableitungsvorrichtung als Ableitungsschlauch, so können die Schläuche parallel vorgeschoben werden. Zuleitungskanal und Ableitungskanal können an ihren der Ätzkammer zugewandten Enden im Bereich des Ätzvorrichtungskopfes enden und in die Ätzkammer münden.

Nach einer weiteren Ausgestaltung kann der Ableitungskanal bzw. Ableitungsschlauch ein Absaugkanal (bzw. Absaugschlauch) sein, d.h. dieser kann an seinem dem Ätzraum gegenüberliegenden Ende mit einer Absaugeinrichtung verbunden sein, welche das Ätzmittel und gelöstes Werkstückmaterial aktiv aus dem Ätzraum absaugt. Die Absaugeinrichtung kann eine Pumpe sein. Gleichsam kann der Zuleitungskanal (bzw. Zuleitungsschlauch) an seinem dem Ätzkanal gegenüberliegenden Ende mit einer Pumpe verbunden sein, über welche Ätzmittel in Richtung des Ätzraums gepumpt werden kann. Dem Ableitungskanal und dem Zuleitungskanal kann eine gemeinsame Pumpe zugeordnet sein, ferner können dem Ableitungskanal und dem Zuleitungskanal jeweils separate Pumpen zugeordnet sein. Die separaten Pumpen können hinsichtlich ihrer Steuerung und Regelung synchronisiert betrieben werden.

Grundsätzlich vorstellbar ist aber auch eine Ausgestaltung, wonach ein und derselbe Kanal temporär als Zuleitungskanal und temporär als Ableitungskanal dient. In diesem Fall würde das Ätzmittel durch ein und denselben Kanal in Richtung des Ätzraums befördert, und nach einer bestimmten Verweilzeit des Ätzmittels an der Bearbeitungsfront samt gelöstem Werkstückmaterial aus dem Ätzraum nach Werkstück-außen befördert werden. In diesem Falle könnte der sowohl als Zuleitungskanal als auch als Ableitungskanal dienende Kanal als einkanaliger Schlauch ausgebildet werden.

Nach einer weiteren Ausgestaltung der Erfindung kann vorgesehen sein, dass der Zuleitungskanal weiter in den Ätzraum hineinragt als der Ableitungskanal oder umgekehrt. Insbesondere jene Variante, wonach der Zuleitungskanal weiter in den Ätzraum hineinragt als der Ableitungskanal, kann vorteilhaft sein, da damit Bearbeitungsfront aus unmittelbarer Nähe mit Ätzmittel angeströmt werden kann. Damit ein besonders effizienter Abtrag von Werkstückmaterial von der Bearbeitungsfront gewährleistet werden. Durch Variation des Abstandes des der Bearbeitungsfront zugewandten Endes des Zuleitungskanals zur Bearbeitungsfront und eine entsprechende Position des der Bearbeitungsfront zugewandten Ableitungskanal-Endes kann die Strömung des Ätzmittels flexibel an die jeweilige Abtragungsaufgabe angepasst werden.

Nach einer weiteren Ausgestaltung der Erfindung kann vorgesehen sein, dass der Zuleitungskanal und der Ableitungskanal eine gemeinsame Baueinheit bilden, wobei der Zuleitungskanal und der Ableitungskanal in einem gemeinsamen, vorzugsweise flexiblen, Versorgungs-Schlauch angeordnet sind. Entsprechend können der Zuleitungskanal- und Ableitungskanal im Sinne einer Schlauch-in-Schlauch-Lösung aufgebaut sein, wobei entweder der Zuleitungskanal innen und der Ableitungskanal außen oder der Ableitungskanal innen und der Zuleitungskanal außen angeordnet sind. Auch können Zuleitungskanal und Ableitungskanal in dem erwähnten Versorgungs-Schlauch nebeneinanderliegend angeordnet sein. In beiden Fällen bilden Zuleitungs- und Ableitungskanal einen zweikanaligen Versorgungs-Schlauch. In einer weiteren Ausgestaltung kann ein mehrkanaliger Versorgungs-Schlauch vorgesehen sein, der einer Mehrzahl von Zuleitungskanälen und/oder Ableitungskanälen umfassen kann. So können über verschiedene Zuleitungskanäle unterschiedliche Ätzmittel, Ätzmittel unterschiedlicher Konzentration oder Temperatur in Richtung des Ätzraums befördert werden. Die Zuleitungs- und Ableitungskanäle können flexibel geschlossen und geöffnet werden, sodass beispielsweise im Falle der Zuleitung eines Ätzmittels in den Ätzraum über einen Zuleitungskanal, ein weiterer Zuleitungskanal (in welchem ein anderes Ätzmittel vorgehalten sein kann) verschlossen ist. Gleiches kann für Ableitungskanäle gelten, die ebenfalls flexibel verschlossen und geöffnet werden können. Bei mehrkanaliger Ausbildung des Versorgungs-Schlauchs kann in dem Versorgungs-Schlauch ein Zuleitungskanal, ein Ableitungskanal und ein Zuflusskanal für ein Neutralisationsmittel/Verdünnungsmittel ausgebildet sein.

Über den Zuflusskanal für das Neutralisationsmittel/Verdünnungsmittel kann der pH Wert oder die Konzentration des Ätzmittels im Ätzraum und somit die Ätzrate (bei Bedarf) eingestellt werden. Insbesondere kann bei einer solchen Ausgestaltung eine pH und/oder Konzentrationsmesseinrichtung an dem Ätzvorrichtungskopf vorgesehen sein, mit welcher eine pH und/oder Konzentrationsbestimmung des im Ätzraum vorliegenden Ätzmittels ermöglicht wird. Sodann kann über eine entsprechende Auswerteeinheit, die Teil einer Steuereinheit der Ätzvorrichtung sein kann, bestimmt werden, ob eine pH oder Konzentrationsanpassung erforderlich ist. Der Zuflusskanal für das Neutralisationsmittel/Verdünnungsmittel kann auch derart geschaltet sein, dass dieser in den Ableitungskanal mündet, um das abgeleitete Ätzmittel schon bei dessen Ableitung durch den Ableitungskanal unmittelbar im Kanal zu neutralisieren/zu verdünnen. Bei Vorsehen eines Zuleitungskanals, eines Ableitungskanals und eines Zuflusskanal für das Neutralisationsmittel/Verdünnungsmittel in einem gemeinsamen Versorgungs-Schlauch wird handelt es sich um eine drei-Kammer-Systemlösung.

Es sei bemerkt, dass ein solcher Zuflusskanal für ein Neutralisationsmittel/Verdünnungsmittel auch in jenem Falle der separaten Ausbildung von Zuleitungskanal (z. B. als Zuleitungsschlauch) und Ableitungskanal (z. B. Ableitungsschlauch) vorgesehen sein kann, beispielsweise als entsprechender separater Zuflussschlauch für Neutralisationsmittel/Verdünnungsmittel.

In einer weiteren Ausgestaltung kann ferner lediglich ein Zuleitungskanal (z. B. als Zuleitungsschlauch) und ein Zuflusskanal (z. B. Zuflussschlauch) für ein Neutralisationsmittel/Verdünnungsmittel vorgesehen sein. In diesem Falle kann das Ätzmittel über den rückwärtig zum Ätzraum gebildeten Hohlraum nach Werkstück-außen abgeführt werden. Vorzugsweise ragt der Zuleitungskanal für das Ätzmittel bei dieser Ausgestaltung in den Ätzraum hinein oder mündet in diesen. Der Zuflusskanal für das Neutralisationsmittel/Verdünnungsmittel ist dabei vorzugsweise im Vergleich zum Zuleitungskanal nach Werkstück-außen rückversetzt und ragt nicht in den Ätzraum hinein (und mündet auch nicht in diesen). Vielmehr wird aus dem Ätzraum in den Hohlraum eintretendes Ätzmittel bei dessen Rückführung verdünnt/neutralisiert.

Nach einer weiteren Ausgestaltung der Erfindung kann vorgesehen sein, dass der Versorgungs-Schlauch beim Eintreiben mittels einer Rotationseinheit zumindest teilweise um seine Längsachse rotiert wird. Ein solcher Versorgungs-Schlauch kann einen immanenten Krümmungsradius aufweisen. Wird ein solcher Versorgungs-Schlauch vorgeschoben, krümmt er sich entlang dieser Eigenkrümmung und erschwert den Vorschub entlang abzweigender Vorschubrichtungen, Krümmungen bei Unregelmäßigkeiten an der Wandung des Hohlraums etc. Die Rotationseinheit kann neben dem Vorschub des Versorgungs-Schlauchs durch die erwähnte Vorschub-Antriebseinheit auch eine Rotation des Versorgungs-Schlauchs um seine Längsachse ermöglichen, um ein vereinfachtes Einfädeln in gewinkelte Teilstrukturen (z. B. Abzweigungskanäle abzweigend von einem Hauptkanal) der Hohlraumstruktur, ein vereinfachtes Herausbewegen aus Kavitäten der Hohlraumstruktur, oder ein vereinfachtes Umgehen von Klemmstellen der Hohlraumstruktur zu gewährleisten. Das gleiche Prinzip kann verwendet werden, wenn lediglich ein einziger Schlauch verwendet wird (z. B. als reiner Zuleitungskanal oder Kanal der sowohl als Zuleitungskanal als auch als Ableitungskanal genutzt werden kann).

Nach einer weiteren Ausgestaltung der Erfindung kann vorgesehen sein, dass die Ätzvorrichtung eine vorzugsweise im Bereich des Ätzvorrichtungskopfes angeordnete bildgebende Positionierhilfe umfasst, die insbesondere eingesetzt wird, um eine Orientierung des Versorgungs-Schlauchs (oder eines anderweitigen Schlauchs, z. B. Zuleitungsschlauchs, Ableitungsschlauchs etc.) in Relation zu einer gewünschten Trajektorie zu erfassen und zur Steuerung des Eintreibens der Ätzvorrichtung, insbesondere eines Vorschiebens der Ätzvorrichtung mit einer Vorschub-Antriebseinheit, und/oder der Rotationseinheit verwendet wird.

Nach einer weiteren Ausgestaltung der Erfindung kann vorgesehen sein, dass die Ätzvorrichtung eine Ultraschalleinheit aufweist (diese kann unmittelbar an dem Ätzvorrichtungskopf, z. B. an einem der Bearbeitungsfront zugewandten Ende des Ätzvorrichtungskopfes, angeordnet sein), die vorzugsweise im Bereich des Ätzvorrichtungskopfes angeordnet ist, und mit welcher Ultraschallwellen in den Ätzraum, insbesondere in Richtung der Bearbeitungsfront, applizierbar sind. Die Ultraschalleinheit kann beispielsweise durch eine oder mehrere Sonotrode(n) oder eines oder mehrere Piezoelemente bereitgestellt werden. Die Ultraschalleinheit wird unmittelbar in die auszubildende Struktur (bei Kanälen in den Kanal) eingebracht und kann den chemischen Ätzvorgang lokal (d.h. vor Ort und direkt im Ätzraum im Bereich der Bearbeitungsfront) unterstützen. Anstelle einer Ultraschalleinheit ist auch die Verwendung anderer Einheiten zur lokalen Unterstützung des chemischen Ätzvorgangs denkbar, beispielsweise einer Einheit zur Erzeugung von Druckluftwellen, einer Einheit zur Applizierung anderweitiger elektromagnetischer Strahlung (andere Wellenlängenbereiche), einer Einheit zur lokalen Druckwellenerzeugung von im Ätzraum vorliegendem flüssigen Ätzmittel, einer Einheit zur lokalen Umwälzung des Ätzmittels im Ätzraum etc.

Alternativ kann vorgesehen sein, dass die Ultraschalleinheit außerhalb des Werkstücks angeordnet ist und Ultraschallwellen von außen in das Werkstück appliziert werden (das Werkstück wird von außerhalb mit Ultraschallwellen angeregt). Beispielsweise kann das Werkstück (trotz des lokalen Eintreibens der Ätzmittelfront mittels des Ätzvorrichtungskopfes in das Werkstück) in einem äußeren Ultraschallbad platziert werden. Das Ultraschallbad ist dabei vorzugsweise nicht mit Ätzmittel gefüllt, sondern mit einer anderweitigen geeigneten Flüssigkeit. Auch kann eine Ultraschalleinheit zur Applizierung der Ultraschallwellen auf einer äußeren Werkstückoberfläche oder in Nähe zu einer äußeren Werkstückoberfläche positioniert werden. Sodann können Ultraschallwellen in Richtung des strukturell modifizierten Werkstückmaterials bzw. in Richtung der Bearbeitungsfront appliziert werden.

Nach einer weiteren Ausgestaltung der Erfindung kann vorgesehen sein, dass das Ätzmittel mit wechselnder Strömungsrichtung in Richtung der wandernden Bearbeitungsfront gepumpt wird. Dies kann insbesondere bei Verwendung eines Zuleitungskanals und eines Ableitungskanals Anwendung finden, nämlich durch wechselndes Schalten der Kanäle als Ableitungskanal und Zuleitungskanal. Dadurch kann eine besonders gute (ggf. turbulente) Durchmischung des Ätzmittels an der Bearbeitungsfront und somit eine besonders effiziente Kontaktierung des Werkstückmaterials gewährleistet werden kann.

Nach einer weiteren Ausgestaltung der Erfindung kann vorgesehen sein, dass der Ätzraum in Richtung nach Werkstück-außen, insbesondere von dem rückwärtig zum Ätzraum angeordneten Hohlraum, durch eine Abdichteinrichtung abgedichtet wird, wobei die Abdichteinrichtung insbesondere zumindest einen im Volumen reversibel expandierbaren Balg umfasst, der in einem expandierten Zustand an einer Wandung des Hohlraums anliegt. In einer weiteren Ausgestaltung der Erfindung können zwei hintereinander angeordnete im Volumen reversibel expandierbare Balge vorgesehen sein und die Abdichteinrichtung bereitstellen. Die Abdichteinrichtung kann die verwendeten Kanäle der Ätzvorrichtung, also den Zuleitungskanal, den Ableitungskanal, den Zuflusskanal für das Neutralisationsmittel/Verdünnungsmittel (je nach Vorsehen und Anordnung der Kanäle) und/oder den Versorgungs-Schlauch umgeben. Entsprechend sind die Kanäle/Schläuche bzw. der Versorgungs-Schlauch durch die Abdichteinrichtung hindurchgeführt. In einer weiteren Ausgestaltung kann vorgesehen sein, dass die Kanäle oder der Versorgungs-Schlauch von einem äußeren Dichtschlauch umgeben sind, der ggf. mit einem Fluid im Volumen expandierbar ist und sich an die Wandung des Hohlraums anlegen und eine Abdichtfunktion bereitstellen kann. Auch kann die Abdichteinrichtung unmittelbar durch den Versorgungs-Schlauch oder im Falle der Verwendung eines einzigen zugleich als Zu- und Ableitungsschlauch dienenden Schlauchs durch diesen gebildet werden. Durch das Hindurchleiten von Ätzmittel oder einem anderen Fluid kann (je nach Flexibilität des Schlauchs) auch dann eine Expansion und Anlage des Schlauchs an einer Wandung des Hohlraums gewährleistet werden.

Nach einer weiteren Ausgestaltung der Erfindung kann vorgesehen sein, dass der Ätzraum in Richtung nach Werkstück-außen von dem rückwärtig zum Ätzraum angeordneten Hohlraum durch eine Abdichteinrichtung abgedichtet wird, wobei die Abdichteinrichtung eine pneumatische Abdichteinrichtung ist, die den rückwärtig zum Ätzraum angeordneten Hohlraum in Richtung des Ätzraums mit einem pneumatischen Fluid, insbesondere Druckluft, beaufschlagt.

Nach einer weiteren Ausgestaltung der Erfindung kann vorgesehen sein, dass die Ätzvorrichtung eine Neutralisationseinrichtung oder eine Verdünnungseinrichtung umfasst, mit der das Ätzmittel vor Ableitung aus dem Ätzraum neutralisiert oder verdünnt wird. Die Neutralisationseinrichtung oder Verdünnungseinrichtung kann beispielsweise den erwähnten Zuflusskanal für das Neutralisationsmittel/Verdünnungsmittel umfassen. Eine Neutralisation einer Säure kann beispielsweise mit einer Base erfolgen, die Neutralisation einer Base mit einer Säure. Eine Verdünnung kann beispielsweise mit einer Verdünnungsflüssigkeit, beispielsweise Wasser, erfolgen.

Nach einer weiteren Ausgestaltung der Erfindung kann vorgesehen sein, dass die Ätzvorrichtung eine vorzugsweise im Bereich des Ätzvorrichtungskopfes angeordnete Heiz- und/oder Lichtbestrahlungseinheit aufweist, mit welcher der Ätzraum lokal beheizt und/oder lichtbestrahlt wird. Eine Lichtbestrahlungseinheit kann beispielsweise eine Lichtquelle sein, die derart angeordnet ist, um im Bereich der Bearbeitungsfront durch Lichtbestrahlung erhöhte Temperaturen zu erreichen. Dies kann beispielsweise zur Einstellung der Ätzrate genutzt werden, da die Ätzeffizienz von Ätzmitteln häufig temperaturabhängig ist. Auch ist vorstellbar bestimmte Schlauchbereiche zu bestrahlen und dort eine Temperaturerhöhung zu bewirken. Dadurch kann die Flexibilität des Schlauchs zu einem gewissen Maß erhöht werden. Auch kann durch eine Lichtbestrahlung eine Anregung von Optroden erfolgen, welche beispielsweise zur Messung von Fluoreszenz (z. B. pH Fluoreszenz), zur Konzentrationsmessung etc. eingesetzt werden können. Mittels solcher Optroden können Informationen über das Ätzmittel im Ätzraum ermittelt werden.

Nach einer weiteren Ausgestaltung der Erfindung kann vorgesehen sein, dass eine Ätzvorrichtung eingesetzt wird, deren Ätzvorrichtungskopf einen vorzugsweise wechselbaren Ätzmittel-Applikationskopf umfasst, der ein Einleiten von Ätzmittel in Richtung der Ätzmittelfront in einem vorgegebenen Konzentrationsgefälle und/oder einem vorgegebenen Strömungsprofil ermöglicht. Beispielsweise kann der Ätzmittel-Applikationskopf eine Perforation durch Schlitze und/oder Mikrobohrungen aufweisen, die die Ausbildung eines speziellen vorteilhaften Konzentrationsgefälles und/oder einer Strömungsrichtung im Bereich der Ätzmittelfront ermöglichen. Die Wechselbarkeit ermöglicht eine flexible Einstellung eines gewünschten Konzentrationsgefälles und/oder eines Strömungsprofils in Anpassung an eine jeweilige Bearbeitungsaufgabe.

Nach einer weiteren Ausgestaltung der Erfindung kann vorgesehen sein, dass eine Ätzvorrichtung eingesetzt wird, an deren Ätzvorrichtungskopf zumindest eine bildgebende und/oder nicht-bildgebende Messeinheit zur bildlichen und/oder nicht-bildlichen Erfassung metrischer, chemischer, physikalischer oder anderweitiger Daten aus dem Ätzraum angeordnet ist. Derartige Daten können beispielsweise zur Prozessüberwachung und Inline-Qualitätskontrolle verwendet werden. Metrische Daten können beispielsweise einen Abstand (Entfernung) zwischen Ätzmittelfront und Ätzvorrichtungskopf betreffen. Chemische Daten können beispielsweise Konzentrationen, pH-Werte etc. sein. Physikalische Daten können beispielsweise Temperaturen, Strömungsdaten etc. sein.

Mit Optroden und pH Sensoren als beispielhaften Messeinheiten können beispielsweise in Abhängigkeit einer H₃O⁺ Ionen Konzentration (z. B. des Ätzmittels im Ätzraum) Unterschiede im elektrischen Signal bzw. ihrer optischen Fluoreszenz erfasst und Rückschlüsse auf die Konzentration des Ätzmittels im Bereich der Ätzmittelfront ermöglicht werden bzw. zur Steuerung einer Ätzmittelzuflussrate bzw. einer Ätzmittelzufluss-Pause eingesetzt werden.

Nach einer weiteren Ausgestaltung kann eine Pumpe verwendet werden, die mehrere Versorgungs-Schläuche oder Zuleitungskanäle parallel mit Ätzmittel speisen kann, wobei deren Durchfluss (-pause), Druck und Konzentration insgesamt bzw. jeweils einzeln flexibel einstellbar und/oder messbar und/oder regelbar ist.

Nach einer weiteren Ausgestaltung der Erfindung kann vorgesehen sein, dass Hilfskanäle in das Werkstück eingebracht werden (dies kann beispielsweise mechanisch erfolgen, aber auch durch einen gesonderten Ätzprozess oder einen gesonderten Laserätzprozess), durch welche die Ätzvorrichtung an eine gewünschte Position verbracht werden kann, und von dieser Position ausgehend ein Ätzvorgang eingeleitet werden kann. Dies bedeutet, dass sich die Ätzvorrichtung samt der von dieser bereitgestellten Ätzmittelfront ausgehend von einer Position im Hilfskanal in das Werkstück eingräbt bzw. eingetrieben wird. Dabei können beispielsweise Abzweigkanäle ausgehend von dem Hilfskanal ausgebildet werden. Der Hilfskanal kann im Werkstück verbleiben, verschlossen werden, gar ist vorstellbar jenen Teil des Werkstücks, in dem der Hilfskanal ausgebildet wurde, vom Rest des Werkstücks mechanisch abzutrennen.

Das mit der Erfindung vorgeschlagene Verfahren (bzw. einzelne Schritte desselbigen) bzw. das mit der Erfindung vorgeschlagene System können computergestützt durchgeführt werden. Dies gilt insbesondere für jene Schritte des Verfahrens, in denen eine Steuerung- und Regelung von Maschinenkomponenten erforderlich ist. Um einige Beispiele zu nennen, kann beispielsweise die Laserbearbeitungsvorrichtung, die Ätzvorrichtung oder die erwähnte Pumpe computergestützt (d.h. unter Einsatz eines Computers) betrieben werden. Eine computergestützte Durchführung/Nutzung schließt die Verwendung von Algorithmen, Routinen, Software etc. ein. Bei einer computergestützten Ausführung des Verfahrens oder Nutzung des Systems können Betriebsparameter computergestützt angepasst, kontrolliert und gesteuert und geregelt werden. Ferner können bei einer computergestützten Ausführung des Verfahrens oder Nutzung des Systems Messparameter computergestützt erfasst und ausgewertet werden.

Weiterhin wird die der vorliegenden Erfindung zugrunde liegende Aufgabe - wie erwähnt - durch ein System zum Ausbilden einer Struktur in einem Werkstück durch selektives Laserätzen gelöst, das System umfassend eine Werkstückaufnahme zur Aufnahme des Werkstücks, eine Laserbearbeitungsvorrichtung, die dazu ausgebildet ist, Laserstrahlung zu erzeugen, und die Laserstrahlung in einen zu der auszubildenden Struktur korrespondierenden Werkstück-Bearbeitungsbereich einzubringen, und somit Werkstückmaterial des Werkstücks in dem Werkstück-Bearbeitungsbereich strukturell zu modifizieren, und eine Ätzvorrichtung, die dazu ausgebildet ist, modifiziertes Werkstückmaterial unter Einsatz eines Ätzmittels von dem Werkstück zu entfernen. Das System zeichnet sich dadurch aus, dass die Ätzvorrichtung dazu ausgebildet ist, zum Entfernen des modifizierten Werkstückmaterials eine Ätzmittelfront zu erzeugen und die Ätzmittelfront entlang des Werkstück-Bearbeitungsbereichs zu führen.

Die Laserbearbeitungsvorrichtung kann einen oder mehrere Laserstrahlen bereitstellen. Mehrere Laserstrahlen können Teilstrahlen sein, die im Wege einer Strahlteilung aus einem einzelnen Laserstrahl erzeugt/geteilt werden. Ferner können mehrere Strahlungsquellen einzelne Laserstrahlen erzeugen und somit die mehreren Laserstrahlen bereitstellen. Auch eine Laserbearbeitungsvorrichtung, die lediglich einen einzelnen Laserstrahl erzeugt und in den Werkstück-Bearbeitungsbereich einbringt, kann erfindungsgemäß vorgesehen sein. Es ist zudem nicht ausgeschlossen, mehrere der beschriebenen Laserbearbeitungsvorrichtungen im Rahmen der Erfindung einzusetzen und das Werkstück mit mehreren Laserbearbeitungsvorrichtungen zu bearbeiten. Vorteilhaft kann insbesondere die Verwendung einer Laserbearbeitungsvorrichtung sein, mit der sich mehrere Teilstrahlen erzeugen und im Werkstück-Bearbeitungsbereich fokussieren lassen. Damit kann die Bearbeitungsgeschwindigkeit inhärent erhöht werden.

Das erfindungsgemäße Verfahren bzw. System kann auf eine Laserbearbeitungsvorrichtung zurückgreifen, welche die strukturelle Modifizierung des Werkstückmaterials mit einem einzelnen Laserstrahl (Einzelstrahlbearbeiten) oder mit mehreren Laserstrahlen (z. B. Teilstrahlen oder einzeln erzeugte Laserstrahlen) durchführt. Letzteres kann als Multistrahl-SLE bezeichnet werden. Dem einzelnen Laserstrahl kann eine Strahlpositionierungseinheit (z. B. Galvanometerscanner) zugeordnet sein. Beim Mulstristrahl-SLE können einer Strahlpositionierungseinheit (z. B. einem Galvanometerscanner) mehrere Laserstrahlen zugeordnet sein, oder mehreren Laserstrahlen (z. B. in Teilstrahlen aufgeteilte Laserstrahlen) kann jeweils eine Strahlpositionierungseinheit (z. B. jeweils ein Galvanometerscanner) zugeordnet sein. Auch kann die Laserbearbeitungsvorrichtung eine Fokussiereinheit zur Fokussierung der Laserstrahlung auf/in das Werkstück aufweisen.

### AUSFÜHRUNGSBEISPIELE FÜR LASERBEARBEITUNGSVORRICHTUNGEN

Nach einem ersten Ausführungsbeispiel zum Aufbau einer Laserbearbeitungsvorrichtung kann bereits die Verwendung einer Laserbearbeitungsvorrichtung vorteilhaft sein, die Laserstrahlung (einen oder mehrere Laserstrahlen) erzeugt (durch eine oder mehrere entsprechende Strahlungsquellen, ggf. in Verbindung mit einem Strahlteiler zur Erzeugung von Teilstrahlen), die eine Strahlpositionierungseinheit (z. B. einen Galvanometerscanner) zur Positionierung und/oder Bewegung des/der Laserstrahls/der Laserstrahlen umfasst, und die eine Fokussiereinheit zur Fokussierung der Laserstrahlung umfasst. Gegebenenfalls kann die Laserbearbeitungsvorrichtung eine Positioniereinheit zum Positionieren des Werkstücks relativ zum Laserstrahl/den Laserstrahlen oder des Laserstrahls/der Laserstrahlen relativ zum Werkstück umfassen, die ein Positionieren in einem über eine von der Strahlpositionierungseinheit zugänglichen Positionierbereich (zwischen Werkstück und Laserstrahl/Laserstrahlen) hinausgehenden Positionierbereich ermöglicht, also eine Art Grobpositionierung.

Nachfolgend sei ein weiteres mögliches Ausführungsbeispiel zu einem möglichen (aber nicht ausschließlichen) Aufbau einer Laserbearbeitungsvorrichtung sei nachfolgend beschrieben, wie Sie im Rahmen der vorliegenden Erfindung zum Einsatz kommen kann. Eine solche Laserbearbeitungsvorrichtung wurde bereits in der Veröffentlichung WO 2020/239846 A1 der Anmelderin offenbart. Der Inhalt der WO 2020/239846 A1 sei vollumfänglich in den Offenbarungsgehalt dieser Anmeldung einbezogen.

Demnach umfasst die Laserbearbeitungsvorrichtung zunächst eine Laserstrahlungsquelle mit der ein Laserstrahl erzeugt und entlang eines optischen Pfades in Richtung des Werkstücks ausgesendet wird, insbesondere in Form von Laserpulsen (Ultrakurzpulsen). Der Laserstrahlungsquelle ist in Strahlrichtung eine Strahlteilungseinheit nachgeordnet. Die Strahlteilungseinheit ist dazu eingerichtet, den Laserstrahl in eine Vielzahl von Teilstrahlen aufzuteilen. Bei der Strahlteilungseinheit kann es sich um ein - an sich bekanntes - diffraktives optisches Element (DOE) handeln. Bereits mit der Strahlteilungseinheit kann die Anzahl der Teilstrahlen T voreingestellt werden. Auch eine Grobeinstellung der in einer Ebene des Werkstücks vorliegenden Abstände zwischen den Laserspots der Teilstrahlen, lässt sich bereits mit der Strahlteilungseinheit einstellen. Mit der Strahlteilungseinheit lässt sich ein Laserstrahl in Teilstrahlen aufteilen, die ein zweidimensionales räumliches Muster von Laserspots bereitstellen. Auch die Einbringung von lediglich einem Teilstrahl in/auf das Werkstück ist möglich.

Bezogen auf den Strahlengang kann nachgeordnet zu der Strahlteilungseinheit eine Maske vorgesehen sein, mit welcher ungewünschte Teilstrahlen von höherer Ordnung herausgefiltert werden können. Bei der Maske handelt es sich um eine optische Maske. Nachgeordnet zu der Maske kann eine erste Relay-Einheit vorgesehen sein. Die Relay-Einheit ist dazu eingerichtet, die auf die Relay-Einheit auftreffenden Teilstrahlen (es handelt sich dabei um die nicht mit der Maske herausgefilterten Teilstrahlen) zu fokussieren und parallel auszurichten. Bei der Relay-Einheit kann es sich um eine Einzellinse handeln (d.h. die Relay-Einheit kann z.B. als Achromat ausgebildet sein), oder aber um ein komplexes Linsensystem.

Nachgeordnet zu der Relay-Einheit kann eine Strahlselektionseinheit vorgesehen sein, die dazu eingerichtet ist, eine erste Anzahl der Teilstrahlen entlang des optischen Pfades in Richtung des zu bearbeitenden Werkstücks weiterzuleiten bzw. auszulenken. Weiterhin ist die Strahlselektionseinheit dazu eingerichtet, eine zweite Anzahl der Teilstrahlen aus dem optischen Pfad abzulenken. Die Ablenkung kann dabei in Richtung eines optisches Nebenpfads erfolgen, beispielsweise in Richtung einer Strahlblockiereinheit.

Nach einer Ausführungsform kann die Strahlselektionseinheit eine Spiegelanordnung umfassen, die aus einem Array einzelner Spiegel zusammengesetzt ist. Bei den Spiegeln kann es sich um MEMS-Spiegel oder Mikrospiegel handeln. Dabei kann vorgesehen sein, dass ein jeder auf die Strahlselektionseinheit auftreffender Teilstrahl auf maximal bzw. genau einen Spiegel auftrifft. Die Spiegel können über eine Steuereinheit einzeln angesteuert und verkippt bzw. bewegt werden, um somit jeden Teilstrahl individuell ablenken zu können. Wie schon erwähnt, kann eine bestimmte Anzahl der Teilstrahlen entlang des optisches Pfads in Richtung des Werkstücks weitergeleitet bzw. abgelenkt werden, oder aber aus dem optischen Pfad entfernt werden.

Die Spiegel können beispielsweise zwei Stellungen einnehmen, insbesondere eine ON-Stellung und eine OFF-Stellung. In der ON-Stellung sind die Spiegel beispielsweise ausgeschaltet, in der OFF-Stellung hingegen sind die Spiegel um einen vorgegebenen Winkel, beispielsweise 10°, in Bezug zu der ON-Position ausgelenkt. Je nach Stellung der Spiegel wird ein auf einen solchen Spiegel auftreffender Teilstrahl entlang des optischen Pfades bzw. einem entsprechenden Strahlengang weitergeleitet (abgelenkt) oder aber entlang eines optischen Nebenpfades (dieser weicht von dem optischen Pfad ab). In dem optischen Nebenpfad kann beispielsweise eine statische Strahlblockiereinheit angeordnet sein. Die dort auftreffenden Teilstrahlen werden also nicht in Richtung des Werkstücks abgelenkt. Die ON-Stellung führt also zu einer Auslenkung der Teilstrahlen in Richtung der Strahlblockiereinheit, während die OFF-Stellung zu einer Weiterleitung der Teilstrahlen entlang des optischen Pfades in Richtung des Werkstücks führt.

Die Strahlselektionseinheit kann in einer alternativen Ausführung auch transmittiv bzw. absorptiv ausgebildet sein, insbesondere als zumindest ein auf einem Chip angeordnetes Blockierelement. Derartige Chips sind jedoch auf dem Markt frei erhältlich (siehe beispielsweise https://www.preciseley.com/mems-optical-shutter.html). Das genannte Blockierelement ist dabei innerhalb einer Chipebene zumindest von einer ersten in eine zweite Stellung bewegbar. In der ersten Stellung ist dabei eine Transmission (also ein Hindurchtreten) eines auf das Blockierelement auftreffenden Teilstrahls ermöglicht. In der zweiten Stellung hingegen ist ein Hindurchtreten eines auf das Blockierelement auftreffenden Teilstrahls verwehrt (Absorption). Das Umschalten des Blockierelements kann über eine Steuereinheit kontrolliert werden.

Eine weitere Maske kann zwischen der ersten Relay-Einheit und der zweiten Relay-Einheit vorgesehen sein. Die Maske kann insbesondere vor der Strahlselektionseinheit angeordnet und zum Herausfiltern höherer Ordnungen und der nullten Ordnung vorgesehen sein.

Nachgeordnet zu der Strahlselektionseinheit kann eine Zoom-Einheit vorgesehen sein. Die Zoom-Einheit kann dazu eingerichtet sein die Teilstrahlen simultan in ihrer Ausrichtung bzw. Neigung und ihrem Abstand relativ zueinander anzupassen. Entsprechend wirkt sich die über die Zoom-Einheit ausgeführte Justierung der Teilstrahlen mittelbar auch auf die Ausrichtung und den Abstand der auf das Werkstück projizierten Laserspots aus. Ein zwischen den Teilstrahlen vorliegender Abstand sowie ein auf dem Werkstück vorliegender Abstand der Laserspots lässt sich über die Zoom-Einheit anpassen.

Nachgelagert zu der Zoom-Einheit kann eine zweite Relay-Einheit angeordnet sein. Die zweite Relay-Einheit ist dazu eingerichtet, die erste Anzahl der Teilstrahlen zu kollimieren, sodass die kollimierten Teilstrahlen in einem nachgeordnet zu der zweiten Relay-Einheit angeordneten Punkt (einem Fokalpunkt) zusammenlaufen. Faktisch wird also ein Bündel von Teilstrahlen im Fokalpunkt zusammengeführt. Auch bei der zweiten Relay-Einheit kann es sich - wie bei der ersten Relay-Einheit - um eine Einzellinse oder um ein komplexes Linsensystem handeln.

Weiterhin kann die Laserbearbeitungsvorrichtung eine Strahlpositionierungseinheit umfassen, bei welcher es sich beispielsweise um einen Galvanometerscanner handeln kann, der dazu eingerichtet ist, zu der ersten Anzahl der Teilstrahlen korrespondierende Laserspots auf/in dem Werkstück abzubilden. Je nach über die Strahlselektionseinheit eingestelltem Pattern, wird also ein definiertes Spotmuster - bzw. eine Anordnung von Teilstrahlen auf das Werkstück projiziert. Entsprechend dem vorliegenden Spotmuster kann mittels der Strahlpositionierungseinheit sowohl eine simultan und synchron ausgeführte Positionierbewegung der auf/in das Werkstück projizierten Laserspots ausgeführt werden, als auch eine simultan und synchron ausgeführte Bearbeitungsbewegung. Die Positionierbewegung kann innerhalb eines über die Strahlpositioniereinheit zugänglichen Scanbereichs ausgeführt werden. Im Wege der beschriebenen Bearbeitungsbewegung können auch Sub-Strukturen einzelner Pixel bearbeitet werden.

Bestandteil der Strahlpositioniereinheit kann zudem eine Fokussiereinheit sein, die jene von dem Galvanometerscanner ausgelenkten Teilstrahlen auf/in das Werkstück fokussiert. Dabei werden die Laserspots der Teilstrahlen auf dem Werkstück abgebildet.

Ein weiteres Ausführungsbeispiel für eine im Rahmen der Erfindung einsetzbare Laserbearbeitungsvorrichtung ist in der Veröffentlichung DE 10 2020 107 760 A1, deren Inhalt hiermit in den Offenbarungsgehalt dieser Anmeldung vollumfänglich einbezogen sei.

Auch anderweitig ausgebildete Laserbearbeitungsvorrichtungen können im Rahmen des erfindungsgemäßen Verfahrens verwendet werden.

Vorzugsweise ist das System zur Ausführung eines erfindungsgemäßen Verfahrens ausgebildet.

Nachfolgend sei die Erfindung anhand von Zeichnungen weiter erläutert. Dort zeigen:
- Fig. 1: ein Werkstück in einer schematischen Seitenansicht, wobei in das Werkstück eine Struktur mit einem erfindungsgemäßen Verfahren eingebracht werden soll;
- Fig. 2: das Werkstück aus Figur 1 mit einer schematischen Darstellung der strukturellen Modifizierung von Werkstückmaterial in einem Werkstück-Bearbeitungsbereich durch Laserstrahlung;
- Fig. 3: das Werkstück aus den Figuren 1 und 2 mit strukturell modifiziertem Werkstückmaterial in dem Werkstück-Bearbeitungsbereich;
- Fig. 4: eine Ausführungsform zur Durchführung des erfindungsgemäßen Verfahrens;
- Fig. 5: eine weitere Ausführungsform zur Durchführung des erfindungsgemäßen Verfahrens;
- Fig. 6: eine weitere Ausführungsform zur Durchführung des erfindungsgemäßen Verfahrens;
- Fig. 7: eine weitere Ausführungsform zur Durchführung des erfindungsgemäßen Verfahrens;
- Fig. 8: eine weitere Ausführungsform zur Durchführung des erfindungsgemäßen Verfahrens;
- Fig. 9: eine weitere Ausführungsform zur Durchführung des erfindungsgemäßen Verfahrens;
- Fig. 10: eine schematische Querschnittsdarstellung eines Versorgungs-Schlauchs;
- Fig. 11: eine schematische Querschnittsdarstellung eines Versorgungs-Schlauchs in einer alternativen Ausführung;
- Fig. 12: eine weitere Ausführungsform zur Durchführung des erfindungsgemäßen Verfahrens;
- Fig. 13: eine weitere Ausführungsform zur Durchführung des erfindungsgemäßen Verfahrens.

Nachfolgend sei anhand der Figuren der Ablauf und bestimmte Ausführungsformen eines Verfahrens zum Ausbilden einer Struktur 1 in einem Werkstück 2 durch selektives Laserätzen beschrieben.

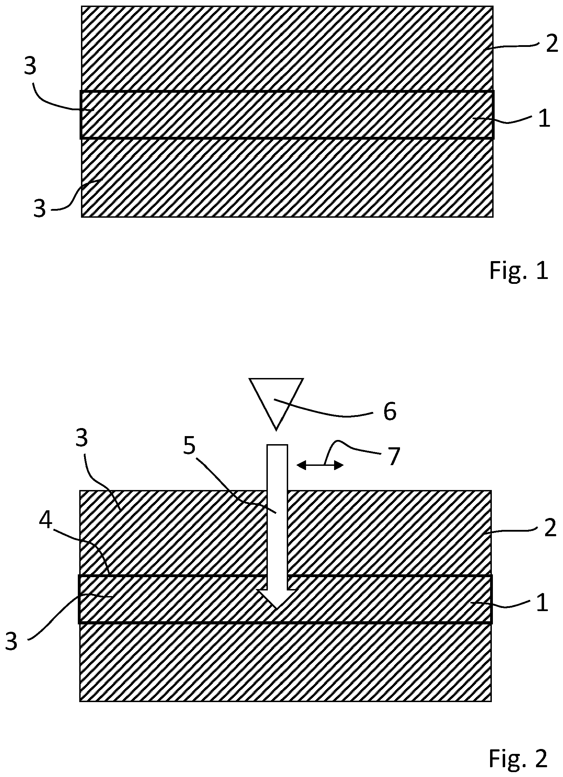

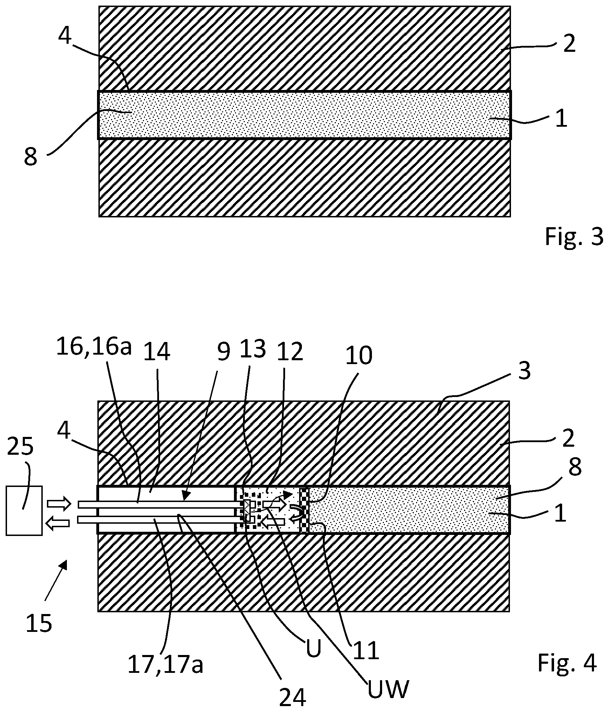

Die Figur 1 zeigt ein Werkstück 2, in welchem eine bestimmte Struktur 2 ausgebildet werden soll. Die Figur 1 zeigt das Werkstück 2 in einer schematischen Seitenansicht. Die gewünschte Struktur 2 (vorliegend ein innerhalb des Werkstücks auszubildender Kanal) ist hinsichtlich der gewünschten Position und eines gewünschten Verlaufs in der Figur 1 kenntlich gemacht. Beim Laserätzen wird zunächst Werkstückmaterial 3 des Werkstücks 2 in einem zu der auszubildenden Struktur 1 korrespondierenden Werkstück-Bearbeitungsbereich 4 des Werkstücks 2 durch Laserstrahlung 5 strukturell modifiziert, wobei bei der strukturellen Modifizierung kein Abtrag des Werkstückmaterials 3 erfolgt. Die Laserstrahlung 5 kann durch einen Laserstrahl oder mehrere Laserstrahlen bereitgestellt werden, die von einer Laserbearbeitungsvorrichtung 6 in Richtung des Werkstück-Bearbeitungsbereichs 4 appliziert und in diesem lokal fokussiert wird. Wie anhand der Pfeildarstellung 7 gezeigt, kann die Laserstrahlung 5 relativ zu dem Werkstück 2, insbesondere dem Werkstück-Bearbeitungsbereich 4 bewegt werden, beispielsweise entlang des Werkstück-Bearbeitungsbereichs 4. Auch kann das Werkstück 2 relativ zur Laserstrahlung 7 bewegt werden oder sowohl das Werkstück 2 als auch die Laserstrahlung 7 werden bewegt. In Folge der Laserbearbeitung liegt in dem Werkstück-Bearbeitungsbereich 4 (strukturell) modifiziertes Werkstückmaterial 8 vor (vgl. Fig. 3).

Nach der strukturellen Modifizierung des Werkstückmaterials 3 durch Laserstrahlung 5 unter Ausbildung von strukturell modifiziertem Werkstückmaterial 8, wird letzteres unter Einsatz eines Ätzmittels von dem Werkstück 2 entfernt wird. Charakteristisch für die vorliegende Erfindung ist, dass das Werkstück 2 dazu nicht - wie aus dem Stand der Technik bekannt - in einem Ätzbad platziert wird, sondern dass zum Entfernen des modifizierten Werkstückmaterials 8 eine von einer Ätzvorrichtung 9 erzeugte Ätzmittelfront 10 entlang des Werkstück-Bearbeitungsbereichs 4 geführt wird. Dieser Vorgang sei anhand der weiteren Figuren erläutert.

Wie in der Figur 4 gezeigt, ist gemäß dem hiesigen Beispiel die in dem Werkstück 2 auszubildende Struktur 1 eine Hohlraumstruktur (nämlich ein entlang des Werkstücks 2 von links nach rechts verlaufender Kanal, also keine Oberflächenstruktur), wobei zur Ausbildung der Hohlraumstruktur ein wandernder Ätzraum 12 entlang des Werkstück-Bearbeitungsbereichs 4 in das Werkstück 2 eingetrieben wird. Dies erfolgt durch Eintreiben eines Ätzvorrichtungskopfes 13 der Ätzvorrichtung 9 samt einer von diesem erzeugten Ätzmittelfront 10 in das Werkstück 2 entlang des Werkstück-Bearbeitungsbereichs 4 unter gleichzeitiger Ausbildung des wandernden Ätzraums 12 und eines die Hohlraumstruktur ausbildenden, rückwärtig zum Ätzraum 12 angeordneten Hohlraums 14, wobei die Ätzmittelfront 10 während des Eintreibens modifiziertes Werkstückmaterial 8 von einer wandernden Bearbeitungsfront 11 löst. Die Bearbeitungsfront 11 liegt der Ätzmittelfront 10 gegenüber. Im vorliegenden Beispiel ragt der Ätzvorrichtungskopf in den Ätzraum 12 hinein, jedoch kann in anderen Ausführungsformen der wandernde Ätzraum 12 auch zwischen dem Ätzvorrichtungskopf 9 und der wandernden Bearbeitungsfront 11 liegen. Das gelöste modifizierte Werkstückmaterial 8 wird mittels der Ätzvorrichtung 9, aus dem Ätzraum 12 nach Werkstück-außen 15 befördert. Die Ätzvorrichtung 9 kann grundsätzlich - wie im Ausführungsbeispiel der Figur 4 exemplarisch gezeigt - eine Ultraschalleinheit U aufweisen, die im Bereich des Ätzvorrichtungskopfes 13 angeordnet ist. Mit der Ultraschalleinheit U werden Ultraschallwellen UW in den Ätzraum 12, nämlich in Richtung der wandernden Bearbeitungsfront 11, appliziert. Dadurch wird die Entfernung von Werkstückmaterial 8 durch Applikation von Ultraschallwellen lokal unterstützt. Eine solche Anordnung kann auch bei den in den weiteren Figuren gezeigten Ausführungsbeispielen eingesetzt werden, ist dort aber nicht gesondert dargestellt.

Wie schon in der Figur 4 schematisch illustriert, weist die Ätzvorrichtung 9 eine Zuleitungsvorrichtung 16 zum Zuleiten des Ätzmittels in den Ätzraum 12 und somit in Richtung der wandernden Bearbeitungsfront 11 auf. Ferner weist die Ätzvorrichtung 9 eine Ableitungsvorrichtung 17 zum Ableiten des Ätzmittels sowie gelöstem modifizierten Werkstückmaterial 8 aus dem Ätzraum 12. Dabei umfasst die Zuleitungsvorrichtung 16 einen Zuleitungskanal 16a, der beispielsweise in Form eines Zuleitungsschlauchs ausgebildet sein kann. Die Ableitungsvorrichtung 17 umfasst einen Ableitungskanal 17a, der in Form eines einen Ableitungsschlauch ausgebildet sein kann. Die Strömung des Ätzmittels ist anhand von Pfeilen dargestellt. Der Zuleitungskanal 16a und Ableitungskanal 16b sind mit einer Pumpe 25 verbunden, über welche das Ätzmittel in Richtung des Ätzraums 12 bzw. von dort nach Werkstück-außen 15 befördert wird.

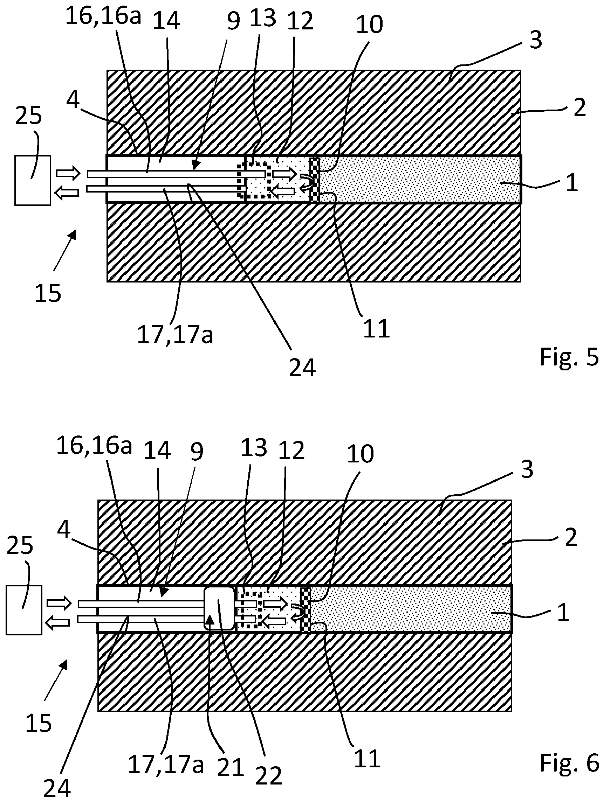

Bei dem in Figur 5 gezeigten Beispiel ragt der Zuleitungskanal 16a weiter in den Ätzraum 12 hinein als der Ableitungskanal 17a, um einen versetzten Rückfluss des Ätzmittels zu ermöglichen.

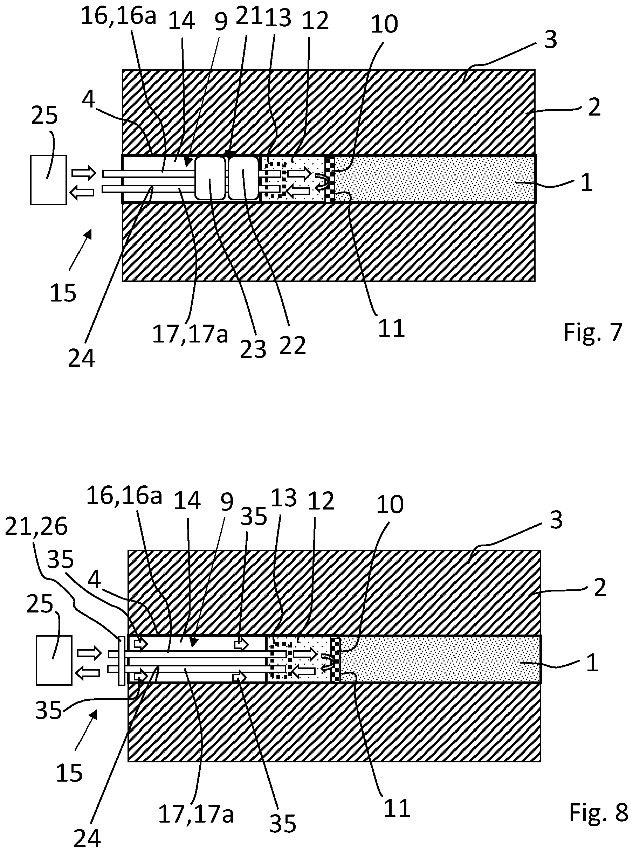

Unabhängig davon, ob der der Zuleitungskanal 16a weiter in den Ätzraum 12 hineinragt als der Ableitungskanal 17a oder nicht, ist bei dem in Figur 6 gezeigten Ausführungsbeispiel vorgesehen, dass der Ätzraum 12 in Richtung nach Werkstück-außen 15, nämlich von dem rückwärtig zum Ätzraum 12 angeordneten Hohlraum 14, durch eine Abdichteinrichtung 21 abgedichtet wird, wobei die Abdichteinrichtung 21 einen im Volumen reversibel expandierbaren Balg 22 umfasst, der in einem expandierten Zustand an einer Wandung 24 des Hohlraums 14 anliegt. Der Zuleitungskanal 16a und Ableitungskanal 17a sind durch den Balg 22 hindurchgeführt bzw. von diesem umgeben. Der Balg 22 kann mit einem Fluid wie Luft aufgeblasen (expandiert) werden. Dazu können entsprechende Leitungen (Luftzufuhr, Luftabfuhr) entlang des Kanals geführt sein (nicht dargestellt). Der Balg 22 kann entsprechende Ventile zur Luftzufuhr und Luftabfuhr aufweisen. Auch können mehrere, zum Beispiel zwei, hintereinander angeordnete Balge 22, 23 eine solche Abdichtung bereitstellen (Fig. 7).

Wie in Figur 8 gezeigt, ist es nach einem weiteren Ausführungsbeispiel möglich, dass der Ätzraum 12 in Richtung nach Werkstück-außen 15 von dem rückwärtig zum Ätzraum 12 angeordneten Hohlraum 14 durch eine Abdichteinrichtung 21 abgedichtet wird, wobei die Abdichteinrichtung 21 eine pneumatische Abdichteinrichtung 26 ist, die den rückwärtig zum Ätzraum 12 angeordneten Hohlraum 14 in Richtung des Ätzraums 12 mit einem pneumatischen Fluid, insbesondere Druckluft, beaufschlagt. Das in den Hohlraum 14 einströmende Fluid ist mit Pfeilen 35 illustriert. Das Fluid hält das Ätzmittel durch den aufgebauten Druck davon ab, in den Hohlraum 14 einzuströmen und verbleibt im Ätzraum 12 bzw. gelangt lediglich durch den Ableitungskanal 17a nach Werkstück-außen 15.

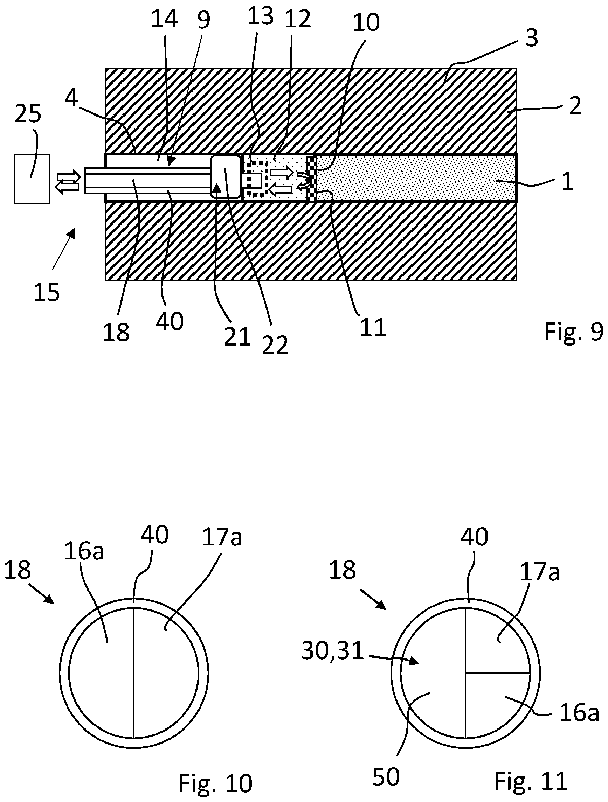

In einer weiteren Ausführungsform (Fig. 9) wird im Vergleich zur Ausführungsform nach Figur 6 ein Versorgungs-Schlauch 18 eingesetzt, der mehrere Kammern aufweist. In dem Versorgungsschlauch 18 ist ein Zuleitungskanal 16a und Ableitungskanal 17a angeordnet. Weiterhin weist der Versorgungsschlauch 18 eine Außenkammer 40 auf, über welchen der Balg 22 mit Fluid, insbesondere Luft, versorgt und dieses Fluid ggf. aus dem Balg abgelassen werden kann. Alternativ kann ein Ablassen des Fluids über ein geeignetes Ablassventil am Balg 22 erfolgen. Diese Variante lässt sich auch bei der Verwendung mehrerer Bälge 22, 23 einsetzen. Der beschriebene Aufbau des Versorgungs-Schlauchs 18 ist auch in Figur 10 in einem schematischen Querschnitt dargestellt.

In einer alternativen Ausführungsform kann der Versorgungs-Schlauch 18 noch weitere Kammern umfassen. Wie in Figur 11 gezeigt, kann eine der Kammern 50 (die Kammer bildet einen sich entlang des Versorgungsschlauches 18 erstreckenden Kanal) Teil einer Neutralisationseinrichtung 30 oder einer Verdünnungseinrichtung 31 sein, mit der das Ätzmittel vor Ableitung aus dem Ätzraum 12 neutralisiert oder verdünnt wird. Entsprechend wird über die Kammer 50 Neutralisationsmittel oder Verdünnungsmittel in Richtung des Ätzraums 12 befördert. Dort kann eine separate Neutralisationskammer/Verdünnungskammer ausgebildet sein, in welcher die Neutralisation/Verdünnung erfolgt. Auch kann die Neutralisation/Verdünnung unmittelbar im Ätzraum 12 erfolgen. Der Versorgungsschlauch 18 kann zudem weitere Kammern umfassen (beispielsweise zur Anordnung von Lichtleitern, Signalkabeln, elektrischen Versorgungskabeln etc.

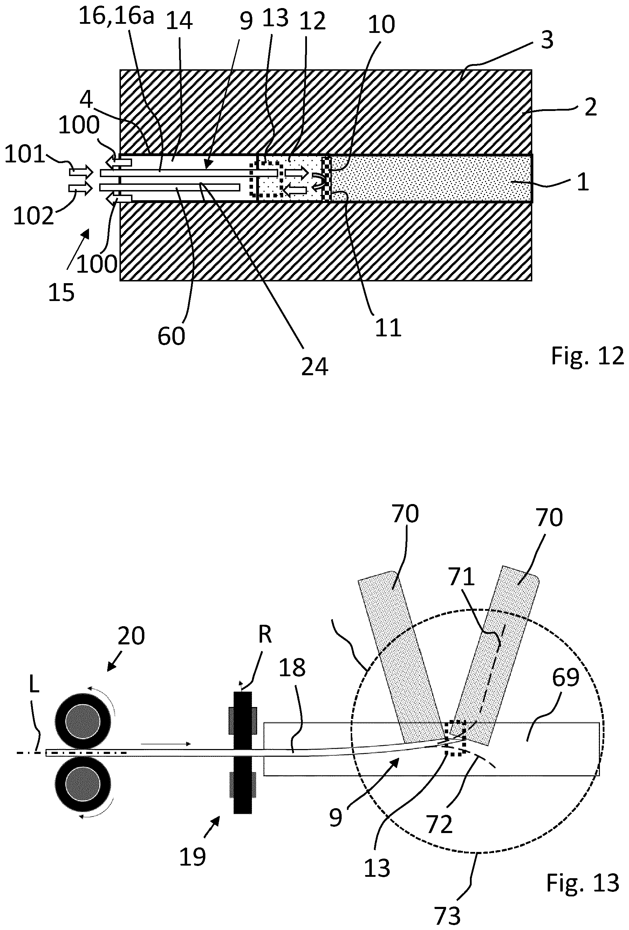

Gemäß einer weiteren Ausführungsform (vgl. Figur 12) wird Ätzmittel wie bei den anderen Varianten über einen Zuleitungskanal 16a (in Form eines Zuleitungsschlauches) in den Ätzraum 12 geleitet. Ein Verdünnungs-/Neutralisationskanal 60 ist zum Zuleitungskanal 16a rückversetzt, ragt also nicht in die Ätzkammer 12 hinein. Über diesen Verdünnungs-/Neutralisationskanal 60 wird Verdünnungsmittel/Neutralisationsmittel in den Hohlraum 14 befördert. Bei dieser Variante kann Ätzmittel (samt gelöstem Werkstückmaterial 3) in den Hohlraum 14 eintreten, wird dort neutralisiert/verdünnt und dann über den Hohlraum 14 nach Werkstück-außen 15 befördert (siehe die Pfeile 100, die das ausströmende neutralisierte/verdünnte Ätzmittel kennzeichnen). Pfeil 101 kennzeichnet in den Zuleitungskanal 16a einströmendes Ätzmittel, während Pfeil 102 in den Verdünnungs-/Neutralisationskanal 60 einströmendes Verdünnungsmittel/Neutralisationsmittel kennzeichnet.

Figur 13 zeigt in einem weiteren Ausführungsbeispiel, dass der Versorgungs-Schlauch 18 beim Eintreiben mittels einer Rotationseinheit 19 zumindest teilweise um seine Längsachse L rotiert wird. Ein solcher Versorgungs-Schlauch 18 (wie auch anderweitige Schläuche) weisen einen immanenten Krümmungsradius auf. Wird ein solcher Versorgungs-Schlauch 18 mittels einer Vorschub-Antriebseinheit 20 vorgeschoben, krümmt er sich entlang dieser Eigenkrümmung und erschwert den Vorschub. Die Rotationseinheit 19 bewirkt neben dem Vorschub des Versorgungs-Schlauchs 18 durch die erwähnte Vorschub-Antriebseinheit 20 eine Rotation R des Versorgungs-Schlauchs 18 um seine Längsachse L, um ein vereinfachtes Einfädeln in gewinkelte Teilstrukturen (z. B. Abzweigungskanäle 70 abzweigend von einem Hauptkanal 69, wobei die Abzweigungskanäle 70 im vorliegenden Beispiel bereits lasermodifiziert wurden) zu gewährleisten. Das gleiche Prinzip kann verwendet werden, wenn lediglich ein einziger Schlauch verwendet wird (z. B. als reiner Zuleitungskanal 16a, oder der sowohl als Zuleitungskanal 16a als auch als Ableitungskanal 17a genutzt werden kann). Durch die Rotation des Versorgungs-Schlauchs 18 wird eine gewünschte Trajektorie 71 erzwungen, während eine ungewünschte Trajektorie 72 verhindert wird.

Die Ätzvorrichtung 9 weist eine vorzugsweise im Bereich des Ätzvorrichtungskopfes 13 angeordnete bildgebende Positionierhilfe (z. B. in Form einer Kamera) auf, die eingesetzt wird, um eine Orientierung des Versorgungs-Schlauchs 18 (oder eines anderweitigen Schlauchs, z. B. Zuleitungsschlauchs, Ableitungsschlauchs etc.) in Relation zu einer gewünschten Trajektorie 71 zu erfassen und zur Steuerung des Eintreibens der Ätzvorrichtung 9, insbesondere eines Vorschiebens der Ätzvorrichtung 9 mit der Vorschub-Antriebseinheit 20, und/oder der Rotationseinheit 19 verwendet wird. Die bildgebende Positionierhilfe kann ein Blickfeld 73 aufweisen, vgl. Fig. 13.

## Patentansprüche

1. Verfahren zum Ausbilden einer Struktur (1) in einem Werkstück (2) durch selektives Laserätzen, wobei
a) Werkstückmaterial (3) des Werkstücks (2) in einem zu der auszubildenden Struktur (1) korrespondierenden Werkstück-Bearbeitungsbereich (4) des Werkstücks (2) durch Laserstrahlung (5) strukturell modifiziert wird; und wobei
b) das modifizierte Werkstückmaterial (8) unter Einsatz eines Ätzmittels von dem Werkstück (2) entfernt wird,
**dadurch gekennzeichnet, dass** zum Entfernen des modifizierten Werkstückmaterials (8) eine von einer Ätzvorrichtung (9) erzeugte Ätzmittelfront (10) entlang des Werkstück-Bearbeitungsbereichs (4) geführt wird.

2. Verfahren nach Anspruch 1, wobei a) und b) im Wesentlichen zeitgleich oder sequenziell ausgeführt werden.

3. Verfahren nach Anspruch 1 oder 2, wobei das Werkstück (2) aus Glas gefertigt ist, insbesondere aus Glaskeramik, Quarzglas, Borosilikatglas, metallischem Glas wie Titanium-Silikatglas, oder Saphir.

4. Verfahren nach einem der vorangehenden Ansprüche, wobei zur strukturellen Modifizierung des Werkstückmaterials (3) in dem Werkstück-Bearbeitungsbereich (4) eine Relativbewegung zwischen dem Laserstrahl oder den mehreren Laserstrahlen und dem Werkstück (2) bereitgestellt wird, nämlich durch
a. Bewegen des Laserstrahls oder der mehreren Laserstrahlen relativ zu dem Werkstück(2), während das Werkstück (2) positionsfest ist;
b. Bewegen des Werkstücks (2) relativ zu dem Laserstrahl oder den mehreren Laserstrahlen, wobei der Laserstrahl oder die mehreren Laserstrahlen positionsfest sind; oder
c. Bewegen des Laserstrahls oder der mehreren Laserstrahlen relativ zu dem Werkstück (2) sowie Bewegen des Werkstücks (2) relativ zu dem Laserstrahl oder den mehreren Laserstrahlen.

5. Verfahren nach einem der vorangehenden Ansprüche, wobei die in dem Werkstück (2) auszubildende Struktur (1) eine Hohlraumstruktur ist, wobei zur Ausbildung der Hohlraumstruktur ein wandernder Ätzraum (12) entlang des Werkstück-Bearbeitungsbereichs (4) in das Werkstück (2) eingetrieben wird, nämlich durch Eintreiben eines Ätzvorrichtungskopfes (13) der Ätzvorrichtung (9) samt einer von diesem erzeugten Ätzmittelfront (10) in das Werkstück (2) entlang des Werkstück-Bearbeitungsbereichs (4) unter gleichzeitiger Ausbildung des wandernden Ätzraums (12) und eines die Hohlraumstruktur ausbildenden, rückwärtig zum Ätzraum (12) angeordneten Hohlraums (14), wobei die Ätzmittelfront (10) während des Eintreibens modifiziertes Werkstückmaterial (8) von einer wandernden Bearbeitungsfront (11) löst.

6. Verfahren nach Anspruch 5, wobei die wandernde Bearbeitungsfront (11) ein wanderndes Ende des Ätzraums (12) bereitstellt.

7. Verfahren nach Anspruch 5 oder 6, wobei der wandernde Ätzraum (12) zwischen dem Ätzvorrichtungskopf (9) und der wandernden Bearbeitungsfront (11) angeordnet ist.

8. Verfahren nach einem der vorangehenden Ansprüche, wobei das gelöste modifizierte Werkstückmaterial (8) mittels der Ätzvorrichtung (9), aus dem Ätzraum (12) nach Werkstück-außen (15) befördert wird.

9. Verfahren nach einem der vorangehenden Ansprüche, wobei das modifizierte Werkstückmaterial (8) in mehreren sequenziell durchgeführten Ätzschritten unter Variation der Art des Ätzmittels, der Konzentration des Ätzmittels, der Temperatur des Ätzmittels und/oder der Verweilzeit des Ätzmittels an der wandernden Bearbeitungsfront (11) von dem Werkstück (2) entfernt wird.

10. Verfahren nach einem der vorangehenden Ansprüche, wobei die Ätzvorrichtung (9) eine Zuleitungsvorrichtung (16) zum Zuleiten des Ätzmittels in den Ätzraum (12) und somit in Richtung der wandernden Bearbeitungsfront (11) umfasst, und ferner eine Ableitungsvorrichtung (17) zum Ableiten des Ätzmittels sowie gelöstem modifizierten Werkstückmaterial (8) aus dem Ätzraum (12) umfasst, wobei die Zuleitungsvorrichtung (16) einen Zuleitungskanal (16a), insbesondere einen Zuleitungsschlauch, umfasst, und wobei die Ableitungsvorrichtung (17) ein Ableitungskanal (17a), insbesondere einen Ableitungsschlauch, umfasst, wobei der Zuleitungskanal (16a) weiter in den Ätzraum (12) hineinragt als der Ableitungskanal (17a) oder umgekehrt.

11. Verfahren nach einem der vorangehenden Ansprüche, wobei der Zuleitungskanal (16a) und der Ableitungskanal (17a) eine gemeinsame Baueinheit bilden, wobei der Zuleitungskanal (16a) und der Ableitungskanal (17a) in einem gemeinsamen, vorzugsweise flexiblen, Versorgungs-Schlauch (18) angeordnet sind, wobei der Versorgungs-Schlauch (18) beim Eintreiben mittels einer Rotationseinheit (19) zumindest teilweise um seine Längsachse (L) rotiert wird.

12. Verfahren nach einem der vorangehenden Ansprüche, wobei die Ätzvorrichtung (9) eine vorzugsweise im Bereich des Ätzvorrichtungskopfes (13) angeordnete bildgebende Positionierhilfe umfasst, die insbesondere eingesetzt wird, um eine Orientierung des Versorgungs-Schlauches (18) in Relation zu einer gewünschten Trajektorie zu erfassen und zur Steuerung des Eintreibens der Ätzvorrichtung (9), insbesondere eines Vorschiebens der Ätzvorrichtung (9) mit einer Vorschub-Antriebseinheit (20), und/oder der Rotationseinheit (19) verwendet wird.

13. Verfahren nach einem der vorangehenden Ansprüche, wobei die Ätzvorrichtung (9) eine Ultraschalleinheit (U) aufweist, die vorzugsweise im Bereich des Ätzvorrichtungskopfes (13) angeordnet ist, und mit welcher Ultraschallwellen (UW) in den Ätzraum (12), insbesondere in Richtung der wandernden Bearbeitungsfront (11), applizierbar sind.

14. Verfahren nach einem der vorangehenden Ansprüche, wobei das Ätzmittel mit wechselnder Strömungsrichtung in Richtung der wandernden Bearbeitungsfront (11) gepumpt wird.

15. Verfahren nach einem der vorangehenden Ansprüche, wobei der Ätzraum (12) in Richtung nach Werkstück-außen (15), insbesondere von dem rückwärtig zum Ätzraum (12) angeordneten Hohlraum (14), durch eine Abdichteinrichtung (21) abgedichtet wird, wobei die Abdichteinrichtung (21) insbesondere zumindest einen im Volumen reversibel expandierbaren Balg (22, 23) umfasst, der in einem expandierten Zustand an einer Wandung (24) des Hohlraums (14) anliegt.

16. Verfahren nach einem der vorangehenden Ansprüche, wobei der Ätzraum (12) in Richtung nach Werkstück-außen (15) von dem rückwärtig zum Ätzraum (12) angeordneten Hohlraum (14) durch eine Abdichteinrichtung (21) abgedichtet wird, wobei die Abdichteinrichtung (21) eine pneumatische Abdichteinrichtung (26) ist, die den rückwärtig zum Ätzraum (12) angeordneten Hohlraum (14) in Richtung des Ätzraums (12) mit einem pneumatischen Fluid, insbesondere Druckluft, beaufschlagt.

17. Verfahren nach einem der vorangehenden Ansprüche, wobei die Ätzvorrichtung (9) eine Neutralisationseinrichtung (30) oder eine Verdünnungseinrichtung (31) umfasst, mit der das Ätzmittel vor Ableitung aus dem Ätzraum (12) neutralisiert oder verdünnt wird, und/oder wobei die Ätzvorrichtung (9) eine vorzugsweise im Bereich des Ätzvorrichtungskopfes (13) angeordnete Heiz- und/oder Lichtbestrahlungseinheit aufweist, mit welcher der Ätzraum (12) lokal beheizt und/oder lichtbestrahlt wird.

18. Verfahren nach einem der vorangehenden Ansprüche, wobei eine Ätzvorrichtung (9) eingesetzt wird, deren Ätzvorrichtungskopf (13) einen vorzugsweise wechselbaren Ätzmittel-Applikationskopf umfasst, der ein Einleiten von Ätzmittel in Richtung der Ätzmittelfront (10) in einem vorgegebenen Konzentrationsgefälle und/oder einem vorgegebenen Strömungsprofil ermöglicht, und/oder an deren Ätzvorrichtungskopf (13) zumindest eine bildgebende und/oder nicht-bildgebende Messeinheit zur bildlichen und/oder nicht-bildlichen Erfassung metrischer, chemischer, physikalischer oder anderweitiger Daten aus dem Ätzraum (12) angeordnet ist.

19. System zum Ausbilden einer Struktur (1) in einem Werkstück (2) durch selektives Laserätzen, umfassend eine Werkstückaufnahme zur Aufnahme des Werkstücks (2), eine Laserbearbeitungsvorrichtung (6), die dazu ausgebildet ist, Laserstrahlung (5) zu erzeugen, und die Laserstrahlung (5) in einen zu der auszubildenden Struktur (1) korrespondierenden Werkstück-Bearbeitungsbereich (4) einzubringen, und somit Werkstückmaterial (3) des Werkstücks (2) in dem Werkstück-Bearbeitungsbereich (4) strukturell zu modifizieren, und eine Ätzvorrichtung (9), die dazu ausgebildet ist, modifiziertes Werkstückmaterial (8) unter Einsatz eines Ätzmittels von dem Werkstück (2) zu entfernen, **dadurch gekennzeichnet, dass** die Ätzvorrichtung (9) dazu ausgebildet ist, zum Entfernen des modifizierten Werkstückmaterials (8) eine Ätzmittelfront (10) zu erzeugen und die Ätzmittelfront (10) entlang des Werkstück-Bearbeitungsbereichs zu führen.
